# EUROPEAN PATENT APPLICATION

(11) **EP 4 276 925 A1**
(43) Date of publication of application: **15.11.2023**
(21) Application number: 21917713.6
(22) Date of filing: 24.12.2021
(51) Int. Cl.: H01L 51/50, C09K 11/06

(54) **ORGANIC ELECTROLUMINESCENT ELEMENT AND METHOD FOR PRODUCING SAME**

(30) Priority: 08.01.2021 JP 2021002315
(71) Applicant: NIPPON STEEL Chemical & Material Co., Ltd., Tokyo 103-0027 (JP)
(72) Inventor: OGAWA, Junya, Tokyo 103-0027 (JP); HAYASHI, Kentaro, Tokyo 103-0027 (JP); YOSHIDA, Kazunari, Tokyo 103-0027 (JP); IKENAGA, Yuji, Tokyo 103-0027 (JP); KITAHARA, Ikumi, Tokyo 103-0027 (JP)
(74) Representative: Vossius & Partner Patentanwälte Rechtsanwälte mbB
(86) International application number: PCT/JP2021/048196
(87) International publication number: WO 2022/149493

(57) **Abstract**

To provide a practically useful organic EL device which is driven at a low voltage and which has high efficiency and lifetime characteristics. The organic EL device includes one or more light-emitting layers between an anode and a cathode opposite to each other, in which at least one of the light-emitting layers contains a first host selected from a biscarbazole compound represented by the following general formula (1) and substituted with at least one triphenylene group, a second host selected from an indolocarbazole compound to which a nitrogen-containing 6-membered ring is bound, and a light-emitting dopant material, where m and n represent the number of repetitions, and m + n ≥ 1 is satisfied.

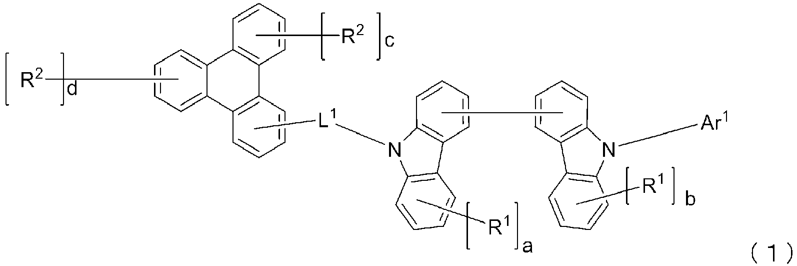

## Description

### Technical Field

The present invention relates to an organic electroluminescent element or device (hereinafter, referred to as an organic EL device), and specifically relates to an organic EL device comprising a specific mixed host material.

### Background Art

Application of a voltage to an organic EL device allows injection of holes and electrons from an anode and a cathode, respectively, into a light-emitting layer. Then, in the light-emitting layer, injected holes and electrons recombine to generate excitons. At this time, according to statistical rules of electron spins, singlet excitons and triplet excitons are generated at a ratio of 1:3. Regarding a fluorescence-emitting organic EL device using light emission from singlet excitons, it is said that the internal quantum efficiency thereof has a limit of 25%. Meanwhile, regarding a phosphorescent organic EL device using light emission from triplet excitons, it is known that intersystem crossing is efficiently performed from singlet excitons, the internal quantum efficiency is enhanced to 100%.

Highly efficient organic EL devices utilizing delayed fluorescence have been developed recently. For example, Patent Literature 1 discloses an organic EL device utilizing a TTF (Triplet-Triplet Fusion) mechanism, which is one of delayed fluorescence mechanisms. The TTF mechanism utilizes a phenomenon in which singlet excitons are generated due to collision of two triplet excitons, and it is thought that the internal quantum efficiency can be theoretically raised to 40%. However, since the efficiency is lower compared to phosphorescent organic EL devices, further improvement in efficiency and low voltage characteristics are required.

Patent Literature 2 discloses an organic EL device utilizing a TADF (Thermally Activated Delayed Fluorescence) mechanism. The TADF mechanism utilizes a phenomenon in which reverse intersystem crossing from triplet excitons to singlet excitons is generated in a material having a small energy difference between a singlet level and a triplet level, and it is thought that the internal quantum efficiency can be theoretically raised to 100%.

Patent Literature 3 discloses use of a compound in which indolocarbazole is substituted with a nitrogen-containing 6-membered ring, as a host material of a light-emitting layer. Patent Literatures 4 and 5 disclose use of a biscarbazole compound as a host material.

Patent Literatures 6, 7, 8, 9, 10, and 11 disclose use of a mixed host material comprising a biscarbazole compound substituted with a triphenylene group, in a light-emitting layer.

However, none of these can be said to be sufficient, and further improvement is desired.

### Citation List

### Patent Literature

Patent Literature 1: WO2010/134350
Patent Literature 2: WO2011/070963
Patent Literature 3: WO2008/056746
Patent Literature 4: JP2008-135498 A
Patent Literature 5: JP2003-133075 A
Patent Literature 6: KR2019/012678
Patent Literature 7: JP2015-180642 A
Patent Literature 8: KR2016-0027940
Patent Literature 9: WO2013/062075
Patent Literature 10: JP2016-111346 A
Patent Literature 11: KR2016-107406

### Summary of Invention

### Technical Problem

Organic EL displays, when compared with liquid crystal displays, are not only characterized by being thin-and-light, high in contrast, and capable of displaying a high-speed moving picture, but also highly valued in terms of designability such as curving and flexibility, and are widely applied in display apparatuses including mobiles and TV. However, organic EL displays are needed to be further reduced in voltage in order to suppress battery consumption in the case of use thereof for mobile terminals, and are inferior as light sources in terms of luminance and lifetime as compared with inorganic LEDs and thus are demanded to be improved in efficiency and device lifetime. In view of the above circumstances, an object of the present invention is to provide a practically useful organic EL device having a low voltage, high efficiency and lifetime characteristics.

As a result of intensive studies, the present inventors have found that the above problem can be solved by an organic EL device using a specific mixed host material in a light-emitting layer, and have completed the present invention.

### Solution to Problem

The present invention relates to an organic EL device comprising one or more light-emitting layers between an anode and a cathode opposite to each other, wherein at least one of the light-emitting layers contains a first host selected from a compound represented by the following general formula (1), a second host selected from a compound represented by the following general formula (2) or general formula (3), and a light-emitting dopant material.

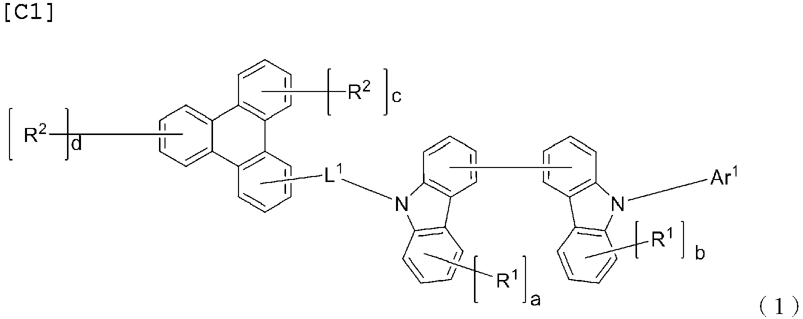

In the general formula (1), Ar¹ represents a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five of these aromatic groups are linked to each other.

L¹ represents a direct bond, a substituted or unsubstituted aromatic hydrocarbon group having 6 to 17 carbon atoms, or a substituted or unsubstituted aromatic heterocyclic group having 3 to 17 carbon atoms.

Herein, when Ar¹ and L¹ represent the aromatic heterocyclic group or the linked aromatic group, a group directly bound to a carbazole ring in the formula is not a carbazolyl group.

R¹ and R² independently are deuterium, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms.
a to d represent the number of substitutions, a and b each independently represent an integer of 0 to 4, and c and d each independently represent an integer of 0 to 2.

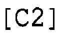

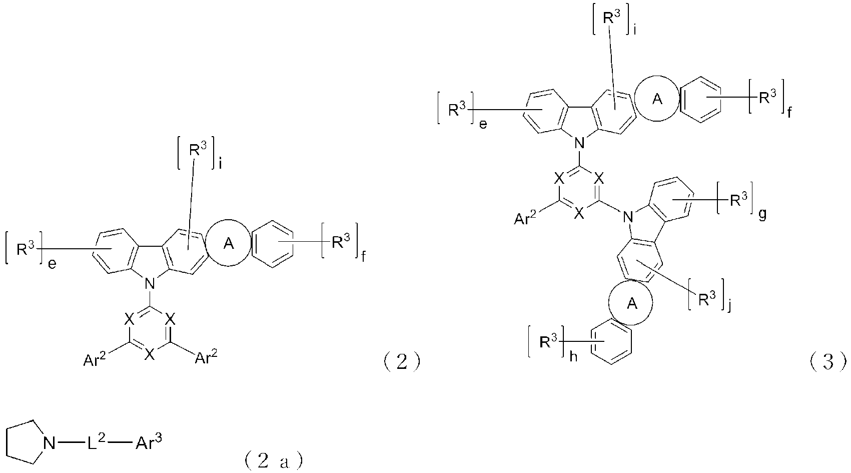

In the general formula (2) and the general formula (3), a ring A is a heterocycle fused to two adjacent rings at any positions and represented by general formula (2a),

Ar² and Ar³ each independently represent a substituted or unsubstituted aromatic hydrocarbon group having 6 to 25 carbon atoms excluding a triphenylene group, a substituted or unsubstituted aromatic heterocyclic group having 3 to 17 carbon atoms, or a substituted or unsubstituted linked aromatic group in which two to five of these aromatic groups are linked to each other, and at least one of Ar² and Ar³ represents a substituted or unsubstituted linked aromatic group in which two to five phenyl groups are linked to each other.

L² represents a direct bond or a substituted or unsubstituted aromatic hydrocarbon group having 6 to 17 carbon atoms.

Each R³ independently represents deuterium, or an aliphatic hydrocarbon group having 1 to 10 carbon atoms.

e to j represent the number of substitutions, e to h each independently represent an integer of 0 to 4, and i to j each independently represent 0 to 2.

X each independently represents N or C-H and at least one or more thereof represent N.

The compound represented by the general formula (1) is preferably represented by the following formula (4) or (5), and is more preferably represented by the following formula (4): 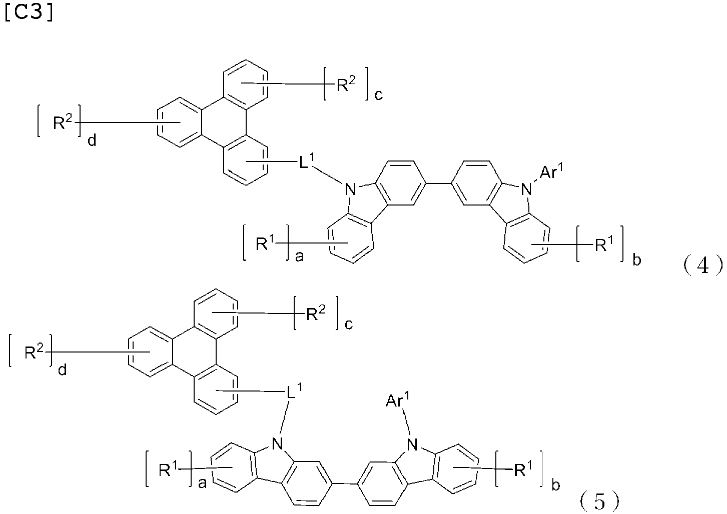 wherein Ar¹, L¹, R¹, R¹, and a to d have the same meaning as in the general formula (1).

In preferred aspects, for example, L¹ represents a direct bond or all of a to d represent 0 in the general formula (1) and the general formulas (4) to (5).

In the general formula (1), Ar¹ preferably represents a substituted or unsubstituted aromatic hydrocarbon group having 6 to 18 carbon atoms, or a substituted or unsubstituted linked aromatic group in which two to five of these aromatic groups are linked to each other, and Ar¹ more preferably represents a substituted or unsubstituted phenyl group, or a substituted or unsubstituted linked aromatic group in which two to five phenyl groups are linked to each other.

The general formula (2) is preferably represented by the following general formulas (6) to (9), is more preferably represented by the general formulas (6) to (8), and is further preferably represented by the general formula (6): 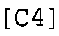 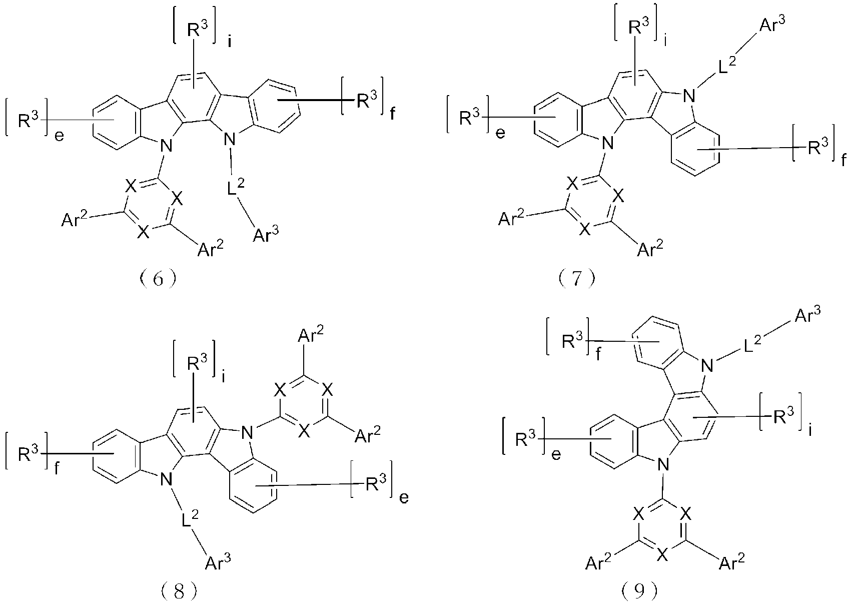 wherein Ar², Ar³, L², R³, e, f, i, and X have the same meaning as in the general formula (2).

The general formula (3) is preferably represented by the following general formulas (10) to (13), is more preferably represented by the general formulas (10) to (12), and is further preferably represented by the general formula (10). 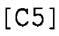 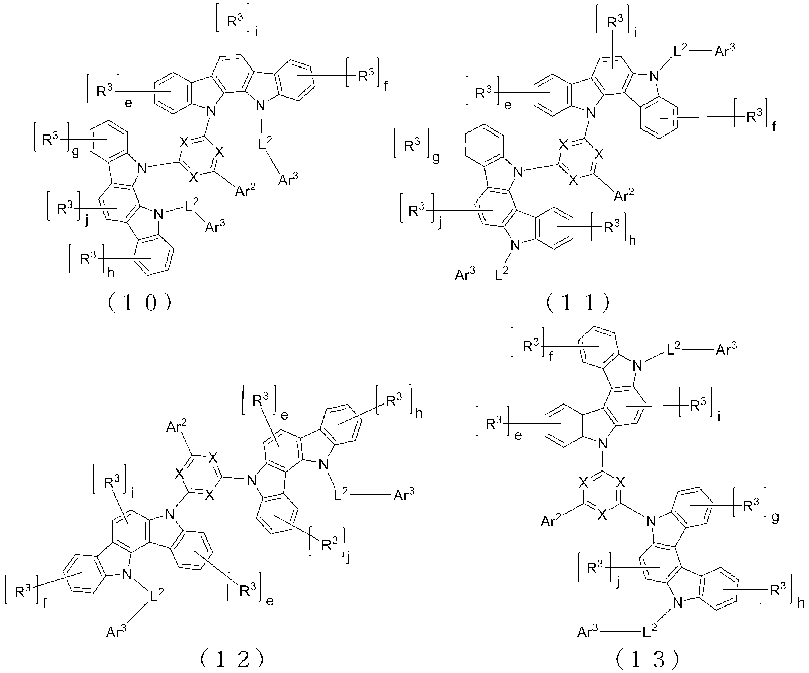 wherein Ar², Ar³, L2, R³, e to j, and X have the same meaning as in the general formula (3).

In preferred aspects, for example, all of X represent N, and Ar³ represents a substituted or unsubstituted aromatic hydrocarbon group having 6 to 18 carbon atoms, or a substituted or unsubstituted linked aromatic group in which two to five of these aromatic groups are linked to each other in the general formulas (2) and (3).

In the general formulas (2) and (3), at least one of Ar² and Ar³ is preferably a group represented by the following general formula (2c): 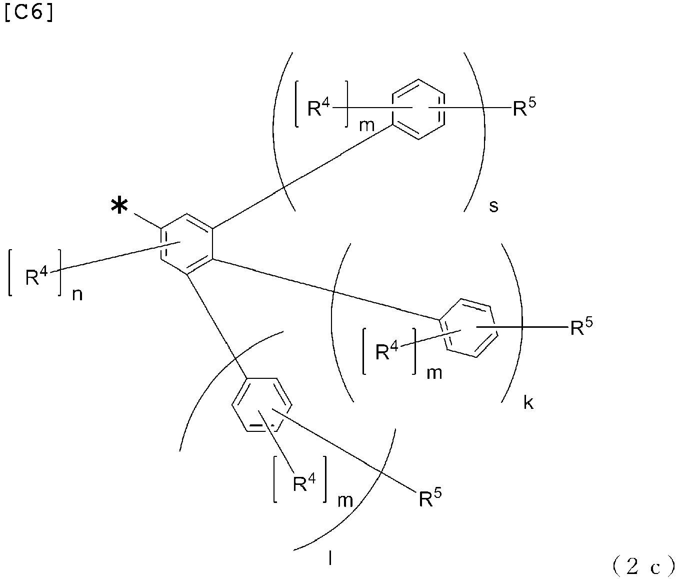 wherein each R⁴ independently represents deuterium or an aliphatic hydrocarbon group having 1 to 10 carbon atoms, each R⁵ independently represents hydrogen, deuterium, or an aliphatic hydrocarbon group having 1 to 10 carbon atoms, each m independently represents an integer of 0 to 4, n represents an integer of 0 to 2, s, k, and 1 represent an integer of 0 to 4, and 1 ≤ s + k + 1 ≤ 4 is satisfied; and * represents a bonding position as a substituent.

The second host is preferably a compound selected from the group consisting of the general formula (2).

The light-emitting dopant material can be an organic metal complex containing at least one metal selected from the group consisting of ruthenium, rhodium, palladium, silver, rhenium, osmium, iridium, platinum and gold, or can be a thermally activated delayed fluorescence-emitting dopant material.

The present invention also relates to a method for producing the organic EL device, comprising a step of mixing the first host and the second host to form a premixture and then vapor-depositing a host material containing the premixture to form a light-emitting layer.

The difference in 50% weight reduction temperatures of the first host and the second host in the premixture is preferably within 20°C. The premixture can be used for the method for producing the organic EL device.

### Advantageous Effects of Invention

According to the present invention, it is considered that a biscarbazole compound represented by the general formula (1) and substituted with at least one or more triphenylene groups, as a first host, and an indolocarbazole compound represented by the general formula (2) or general formula (3), to which a nitrogen-containing 6-membered ring is bound, as a second host are mixed and used to thereby allow a low voltage to be exhibited due to high hole injectability of the first host and high electron injectability of the second host and, in addition, it is considered that an organic EL device exhibiting a low voltage and a favorable device lifetime due to favorable skeleton stability of a constituent material is obtained.

### Brief Description of Drawing

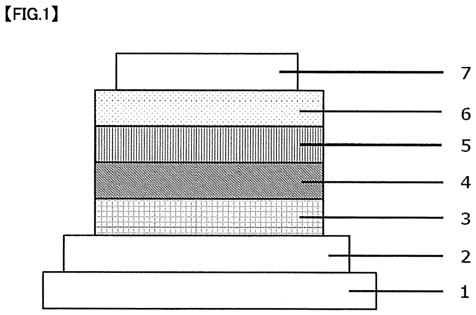

[Figure 1] Figure 1 is a schematic cross-sectional view showing one example of an organic EL device.

### Description of Embodiments

An organic EL device of the present invention is an organic EL device having a plurality of organic layers between an anode and a cathode, wherein the organic layers comprise at least one light-emitting layer, and the light-emitting layer comprises a first host represented by the general formula (1), a second host represented by the general formula (2) or (3), and a dopant material.

In the general formula (1), two carbazole rings can be each bound at the 2-position, the 3-position, or the 4-position, and are preferably each bound at the 3-position as shown in the general formula (4). Herein, in the general formulas (1), (4), and (5), the same symbols have the same meaning.

Ar¹ each independently represents a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five of these aromatic groups are linked to each other. Preferred is a substituted or unsubstituted aromatic hydrocarbon group having 6 to 18 carbon atoms, or a linked aromatic group in which two to five of these aromatic hydrocarbon groups are linked to each other, and more preferred is a substituted or unsubstituted phenyl group, biphenyl group, terphenyl group, or triphenylene group. Herein, when Ar¹ represents the aromatic heterocyclic group or the linked aromatic group, a group directly bound to N in a carbazole ring in the formula is not a carbazolyl group. In other words, when Ar¹ represents the aromatic heterocyclic group, the above group directly bound to N is not a carbazolyl group, and, for example, when Ar¹ represents a linked aromatic group such as Ar¹-Ar⁴-Ar⁵-, a tip group (Ar⁵) bound to N is not a carbazolyl group.

a to d represent the number of substitutions, a and b each independently represent an integer of 0 to 4, c and d each independently represent an integer of 0 to 2. Preferably, a and b represent an integer of 0 to 2, and c and d represent an integer of 0 to 1, and more preferably all of a to d represent 0.

Specific examples of the unsubstituted aromatic hydrocarbon group having 6 to 18 carbon atoms, the unsubstituted aromatic heterocyclic group having 3 to 17 carbon atoms, or the linked aromatic group in which two to five of these aromatic groups are linked to each other include a group generated by removing one hydrogen from benzene, naphthalene, acenaphthene, acenaphthylene, azulene, anthracene, chrysene, pyrene, phenanthrene, fluorene, triphenylene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, benzoquinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, 9,9'-spirobifluorene, carbazole, or compounds in which two to five of these are linked to each other. Preferred examples thereof include a group generated from benzene, naphthalene, acenaphthene, acenaphthylene, azulene, anthracene, chrysene, pyrene, phenanthrene, fluorene, triphenylene, or compounds in which two to five of these are linked to each other. More preferred is a phenyl group, a biphenyl group, a terphenyl group, and a triphenylene group. The terphenyl group may be linked linearly or branched. Herein, a group generated from carbazole is encompassed as a group other than a tip of the linked aromatic group directly bound to N in a carbazole ring in the formula.

L¹ represents a direct bond, a substituted or unsubstituted aromatic hydrocarbon group having 6 to 17 carbon atoms, or a substituted or unsubstituted aromatic heterocyclic group having 3 to 17 carbon atoms excluding a carbazole group. Preferred is a direct bond or a substituted or unsubstituted phenylene group, and more preferred is a direct bond.

When L¹ represents an unsubstituted aromatic hydrocarbon group having 6 to 17 carbon atoms or a substituted or unsubstituted aromatic heterocyclic group having 3 to 17 carbon atoms, the same as in the case of Ar¹ being an unsubstituted aromatic hydrocarbon group and unsubstituted aromatic heterocyclic group is applied except that L¹ represents a divalent group generated by removing two hydrogen atoms from the aromatic hydrocarbon compound and represents an aromatic hydrocarbon group having 6 to 17 carbon atoms.

R¹ and R² each independently represent deuterium, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms. Preferred is deuterium, or a substituted or unsubstituted aromatic hydrocarbon group having 6 to 18 carbon atoms, and more preferred is a substituted or unsubstituted phenyl group.

Specific examples of the aliphatic hydrocarbon group having 1 to 10 carbon atoms include methyl, ethyl, propyl, isopropyl, butyl, t-butyl, pentyl, neopentyl, hexyl, heptyl, octyl, nonyl, and decyl. Preferred is methyl, ethyl, t-butyl, or neopentyl, and more preferred is methyl.

When R¹ and R² represent an unsubstituted aromatic hydrocarbon group having 6 to 18 carbon atoms or an unsubstituted aromatic heterocyclic group having 3 to 17 carbon atoms, the same as in the case of Ar¹ is applied. Preferred is a phenyl group, a pyridine group, a pyrimidine group, a triazine group, or a quinazoline group, and more preferred is a phenyl group.

In the present specification, the linked aromatic group refers to an aromatic group in which the carbon atoms of the aromatic rings in two or more aromatic groups are linked to each other by a single bond. The linked aromatic group may be linear or branched, and is preferably linear. The linkage position in linking of benzene rings may be any of the ortho-, meta-, and para-positions, and is preferably the para-position or the meta-position. The aromatic group may be an aromatic hydrocarbon group or an aromatic heterocyclic group, and the plurality of aromatic groups may be the same or different. The aromatic group corresponding to the linked aromatic group is different from the substituted aromatic group.

In the present specification, aromatic hydrocarbon group, aromatic heterocyclic group, or linked aromatic group may each have a substituent. In the case of having a substituent, the substituent is preferably deuterium, halogen, a cyano group, a triarylsilyl group, an aliphatic hydrocarbon group having 1 to 10 carbon atoms, an alkenyl group having 2 to 5 carbon atoms, an alkoxy group having 1 to 5 carbon atoms, or a diarylamino group having 12 to 44 carbon atoms, more preferably deuterium or an aliphatic hydrocarbon group having 1 to 10 carbon atoms. In the case of the substituent being an aliphatic hydrocarbon group having 1 to 10 carbon atoms, the substituent may be linear, branched, or cyclic. When the aromatic ring of the aromatic hydrocarbon group, the aromatic heterocyclic group, or the linked aromatic group is substituted with the triarylsilyl group or the diarylamino group, silicon and carbon, or nitrogen and carbon are linked to each other by a single bond.

Note that the number of substituents is 0 to 5 and preferably 0 to 2. When an aromatic hydrocarbon group and an aromatic heterocyclic group have substituents, the calculation of the number of carbon atoms does not include the number of carbon atoms of the substituents. However, it is preferred that the total number of carbon atoms including the number of carbon atoms of substituents satisfy the above range.

Specific examples of the cyano group, the triarylsilyl group, the aliphatic hydrocarbon group having 1 to 10 carbon atoms, the alkenyl group having 2 to 5 carbon atoms, the alkoxy group having 1 to 5 carbon atoms, or the diarylamino group having 12 to 44 carbon atoms, as the substituent, include cyano, methyl, ethyl, propyl, i-propyl, butyl, t-butyl, pentyl, neopentyl, cyclopentyl, hexyl, cyclohexyl, heptyl, octyl, nonyl, decyl, vinyl, propenyl, butenyl, pentenyl, methoxy, ethoxy, propoxy, butoxy, pentoxy, diphenylamino, naphthylphenylamino, dinaphthylamino, dianthranylamino, diphenanthrenylamino, and dipyrenylamino. Preferred examples thereof include cyano, methyl, ethyl, t-butyl, propyl, butyl, pentyl, neopentyl, hexyl, heptyl, or octyldiphenylamino, naphthylphenylamino, or dinaphthylamino.

Herein, some or all hydrogen atoms of the unsubstituted aromatic hydrocarbon group, the unsubstituted aromatic heterocyclic group, the unsubstituted linked aromatic group, or the aliphatic hydrocarbon group may be deuterated. When such a group has a substituent, some or all hydrogen atoms of the substituent may be deuterated.

Specific examples of the compounds represented by the general formula (1) are shown below, but are not limited to these exemplified compounds.

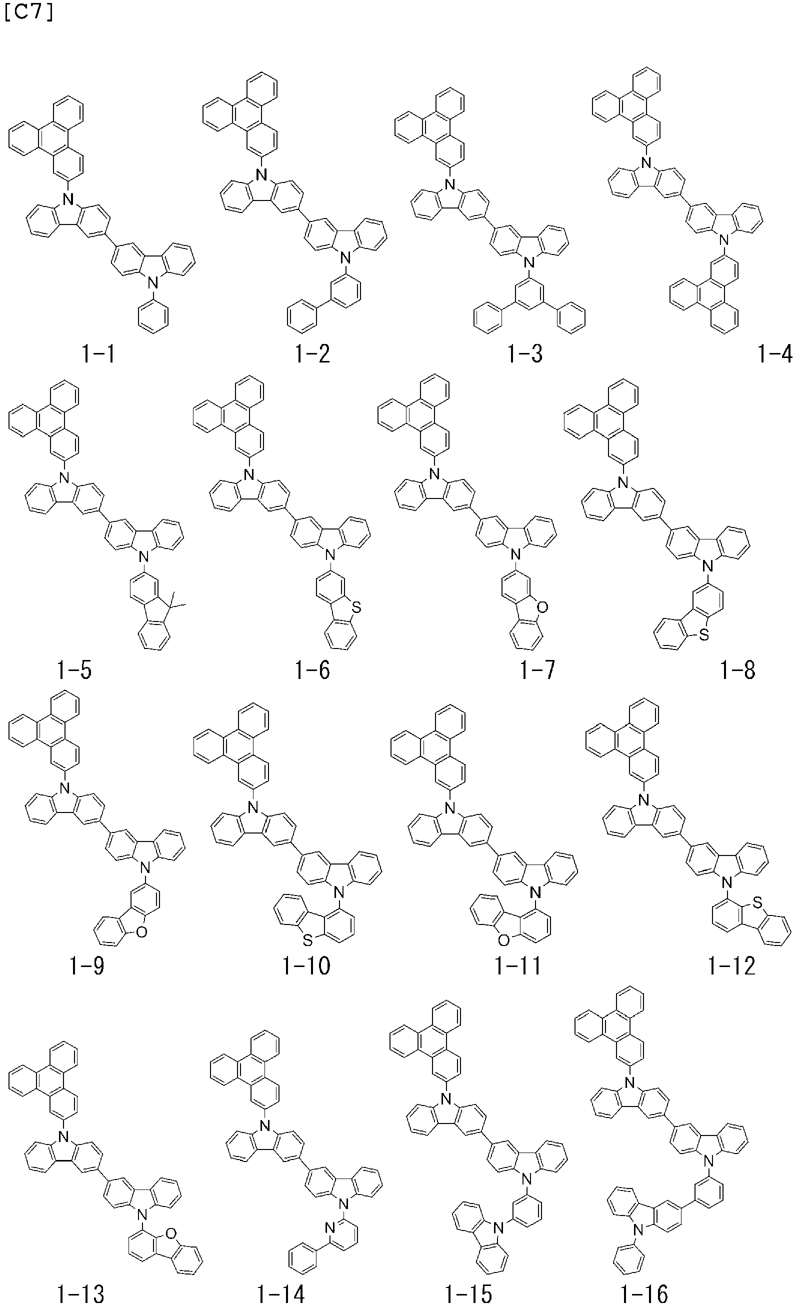

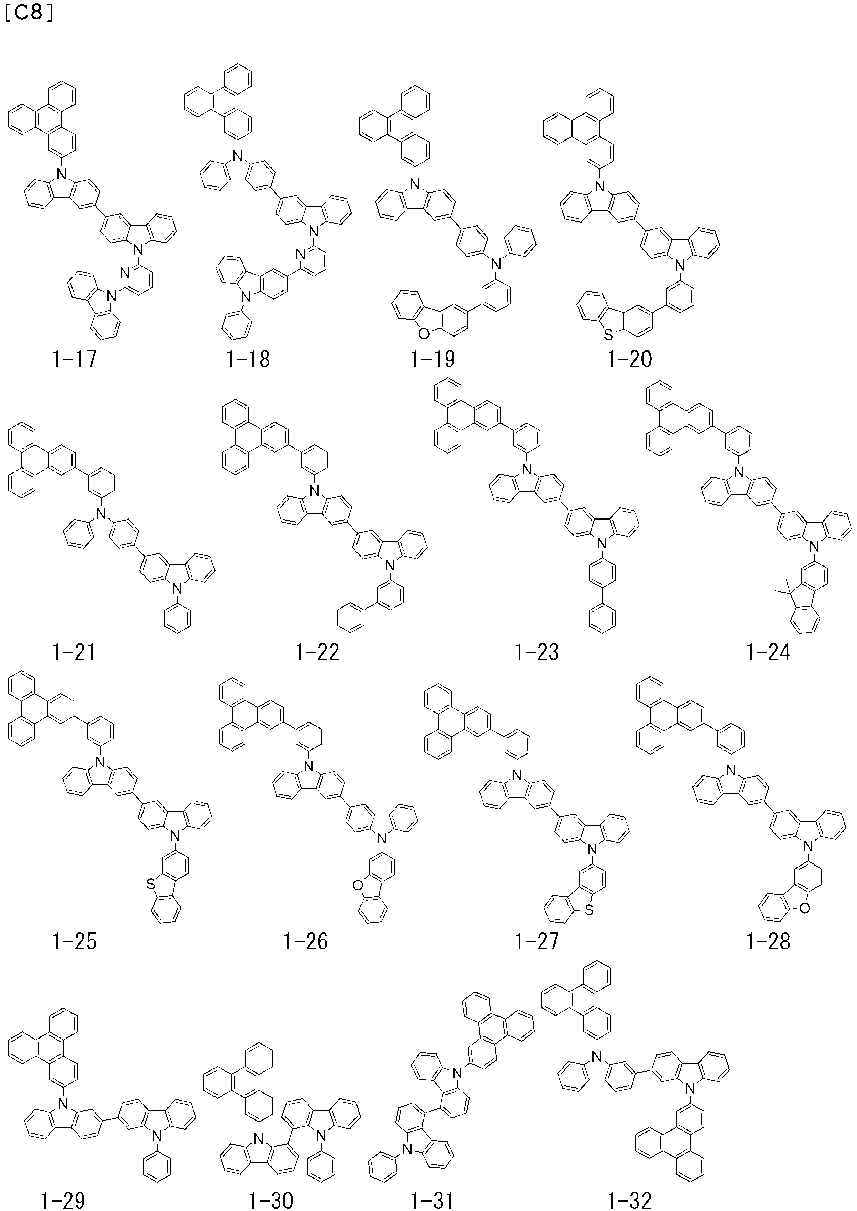

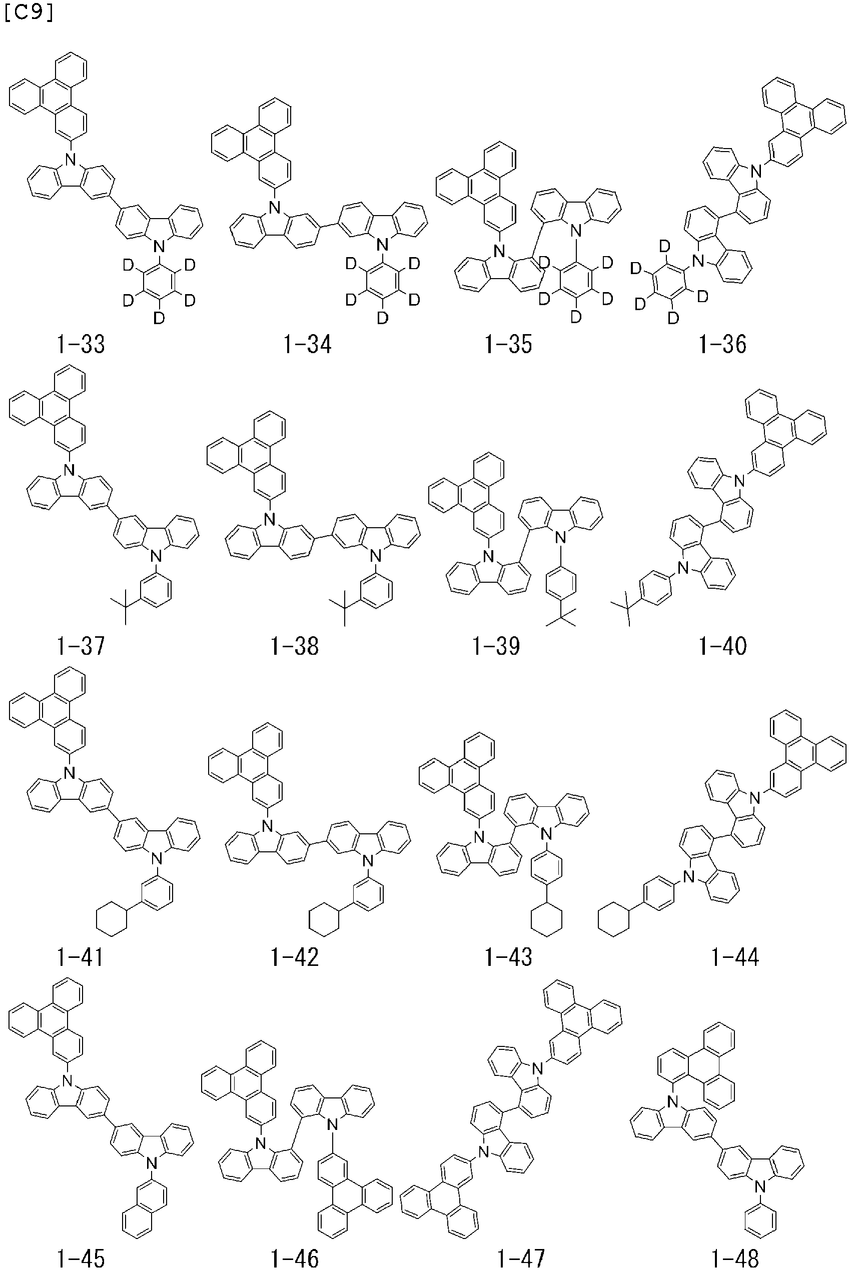

In the general formula (2) or (3), a ring A is a 5-membered heterocycle represented by general formula (2a) and is fused to two adjacent rings at any positions, but is not fused at a side containing N. Hence, an indolocarbazole ring has some isomeric structures, but the number of the structures is restricted.

Specifically, any structure represented by the formulas (6) to (13) can be contained. Preferred is any structure represented by the formulas (6) to (8) or the formulas (10) to (12), and more preferred is any structure represented by the formulas (6) to (8).

In the case of one represented by the general formula (3), an asymmetric structure having indolocarbazole ring isomers different from each other may be contained.

In the general formulas (2) and (3) and the formulas (6) to (13), the same symbols have the same meaning. The general formulas (2) and (3) are interpreted to encompass the general formula (2a).

Each X independently represents N or C-H and at least one thereof represents N. Preferably, two or more X represent N. More preferably, all of X represent N.

e to j represent the number of substitutions, e to h each independently represent an integer of 0 to 4, and i to j each independently represent an integer of 0 to 2. Preferably, e to h represent an integer of 0 to 2, and more preferably all of e to j represent 0.

Each Ar² independently represents a substituted or unsubstituted aromatic hydrocarbon group having 6 to 25 carbon atoms, a substituted or unsubstituted aromatic heterocyclic group having 3 to 17 carbon atoms, or a substituted or unsubstituted linked aromatic group in which two to five of these aromatic groups are linked to each other. Preferred is a substituted or unsubstituted aromatic hydrocarbon group having 6 to 18 carbon atoms, or a substituted or unsubstituted linked aromatic group in which two to five of these aromatic groups are linked to each other. More preferred is a substituted or unsubstituted phenyl group, or a substituted or unsubstituted linked aromatic group in which two to three phenyl groups are linked to each other. Note that, for the purpose of avoiding overlap with the compound of the general formula (1) for the first host, the aromatic hydrocarbon group having 6 to 25 carbon atoms in the definition of Ar² of the general formulas (2) and (3) is excluded if it is a triphenylene group. The same applies to Ar³ described later.

Specific examples of the unsubstituted aromatic hydrocarbon group having 6 to 25 carbon atoms, the unsubstituted aromatic heterocyclic group having 3 to 17 carbon atoms, or the linked aromatic group in which two to five of these aromatic groups are linked to each other include a group generated by removing one hydrogen from benzene, naphthalene, acenaphthene, acenaphthylene, azulene, anthracene, chrysene, pyrene, phenanthrene, fluorene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, benzoquinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, carbazole, 9,9'-spirobifluorene, or compounds in which two to five of these are linked to each other. Preferred examples thereof include a group generated from benzene, naphthalene, acenaphthene, acenaphthylene, azulene, anthracene, chrysene, pyrene, phenanthrene, fluorene, or compounds in which two to five of these are linked to each other. More preferred is a phenyl group, a biphenyl group, or a terphenyl group. The terphenyl group may be linked linearly or branched.

Each Ar³ independently represents a substituted or unsubstituted aromatic hydrocarbon group having 6 to 25 carbon atoms, a substituted or unsubstituted aromatic heterocyclic group having 3 to 17 carbon atoms, or a substituted or unsubstituted linked aromatic group in which two to five of these aromatic groups are linked to each other. Preferred is a substituted or unsubstituted aromatic hydrocarbon group having 6 to 18 carbon atoms, a substituted or unsubstituted aromatic heterocyclic group having 3 to 12 carbon atoms, or a substituted or unsubstituted linked aromatic group in which two to five of these aromatic groups are linked to each other. More preferred is a substituted or unsubstituted phenyl group, a substituted or unsubstituted pyridine group, a substituted or unsubstituted pyrimidine group, substituted or unsubstituted triazine group, or a substituted or unsubstituted linked aromatic group in which two to three phenyl groups are linked to each other.

Specific examples of the unsubstituted aromatic hydrocarbon group having 6 to 25 carbon atoms, the unsubstituted aromatic heterocyclic group having 3 to 17 carbon atoms, or the linked aromatic group in which two to five of these aromatic rings are linked to each other include a group generated by removing one hydrogen from benzene, naphthalene, acenaphthene, acenaphthylene, azulene, anthracene, chrysene, pyrene, phenanthrene, fluorene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, benzoquinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, carbazole, 9,9'-spirobifluorene, or compounds in which two to five of these are linked to each other. Preferred examples thereof include a group generated from benzene, naphthalene, acenaphthene, acenaphthylene, azulene, anthracene, chrysene, pyrene, phenanthrene, fluorene, pyridine, pyrimidine, triazine, quinoxaline, quinazoline, benzoquinazoline, or compounds in which two to five of these are linked to each other. More preferred is a phenyl group, a biphenyl group, a terphenyl group, a pyridine group, a pyrimidine group, a triazine group, or a quinazoline group. The terphenyl group may be linked linearly or branched.

At least one of Ar² and Ar³ represents a substituted or unsubstituted linked aromatic group in which two to five phenyl groups are linked to each other. Preferred is a group represented by the following general formula (2c) : 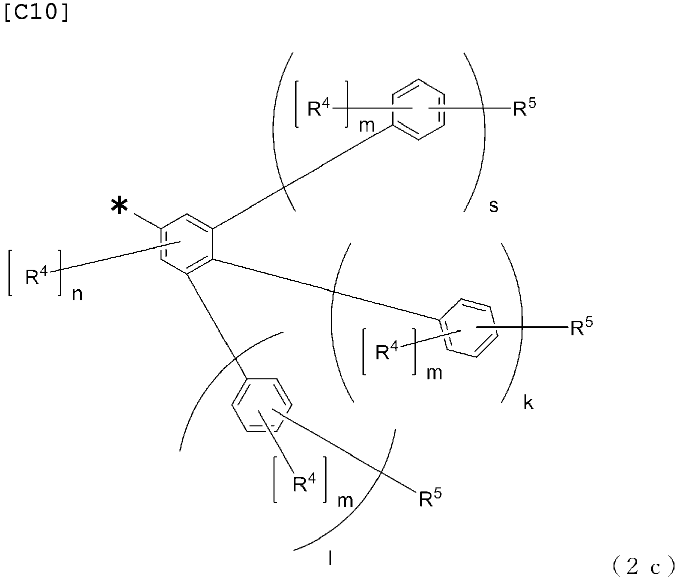 wherein each R⁴ independently represents deuterium or an aliphatic hydrocarbon group having 1 to 10 carbon atoms, each R⁵ independently represents hydrogen, deuterium, or an aliphatic hydrocarbon group having 1 to 10 carbon atoms, each m independently represents an integer of 0 to 4, n represents an integer of 0 to 2, s, k, and 1 represent an integer of 0 to 4, and 1 ≤ s + k + l ≤ 4 is satisfied; * represents a bonding position as a substituent; m and n are preferably from 0 to 1, and more preferably 0; S, k, and 1 are preferably from 0 to 3, and more preferably 0 to 2; and 1 ≤ s + k + 1 ≤ 3 is preferably satisfied, and 2 ≤ s + k + 1 ≤ 3 is more preferably satisfied.

L² represents a direct bond or a substituted or unsubstituted aromatic hydrocarbon group having 6 to 17 carbon atoms. Preferred is a direct bond or a substituted or unsubstituted phenylene group.

When L² represents an unsubstituted aromatic hydrocarbon group having 6 to 17 carbon atoms, the same as in the case of Ar³ being an unsubstituted aromatic hydrocarbon group is applied except that L² represents a divalent group generated by removing two hydrogen atoms from the aromatic hydrocarbon compound and represents an aromatic hydrocarbon group having 6 to 17 carbon atoms.

Each R³ independently represents deuterium or an aliphatic hydrocarbon group having 1 to 10 carbon atoms, preferably represents deuterium or an aliphatic hydrocarbon group carbon having 1 to 4 carbon atoms, and more preferably represents deuterium.

Specific examples of the aliphatic hydrocarbon group having 1 to 10 carbon atoms include methyl, ethyl, propyl, isopropyl, butyl, t-butyl, pentyl, neopentyl, hexyl, heptyl, octyl, nonyl, and decyl. Preferred examples thereof include methyl, ethyl, t-butyl, or neopentyl, and more preferred examples thereof include methyl.

Specific examples of the compounds represented by the general formula (2) are shown below, but are not limited to these exemplified compounds.

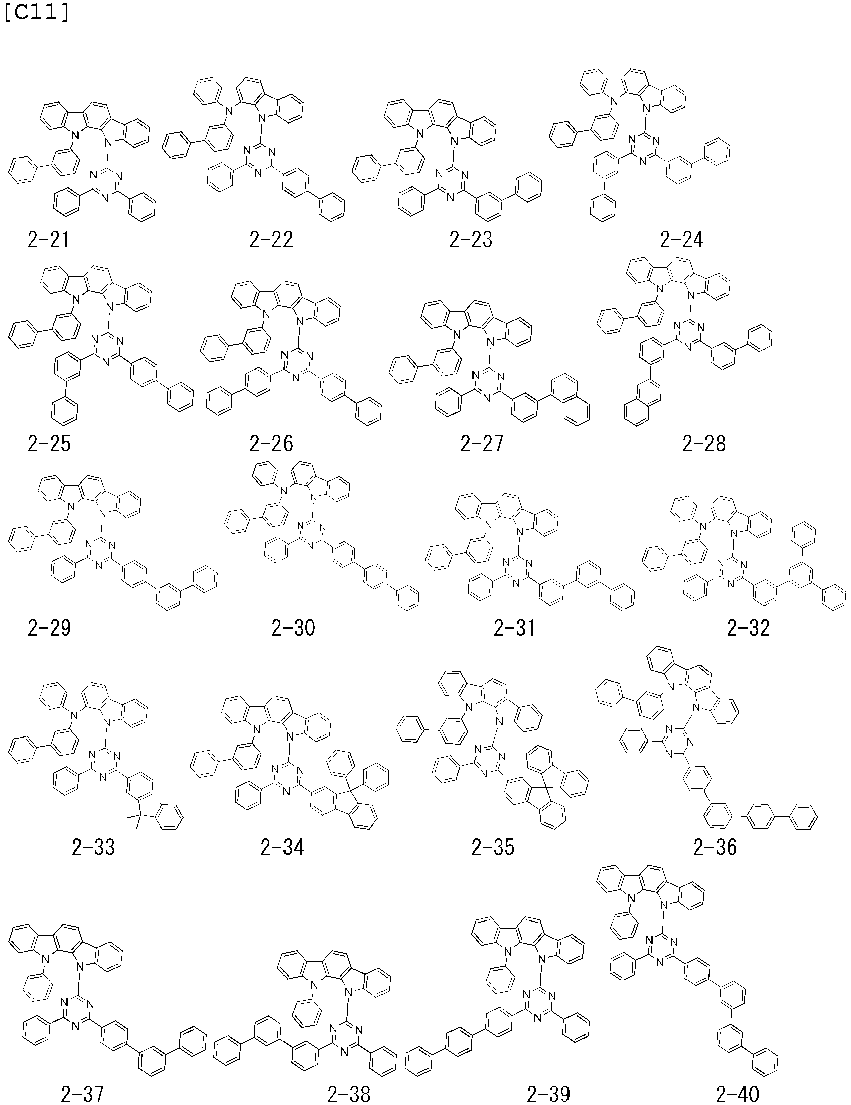

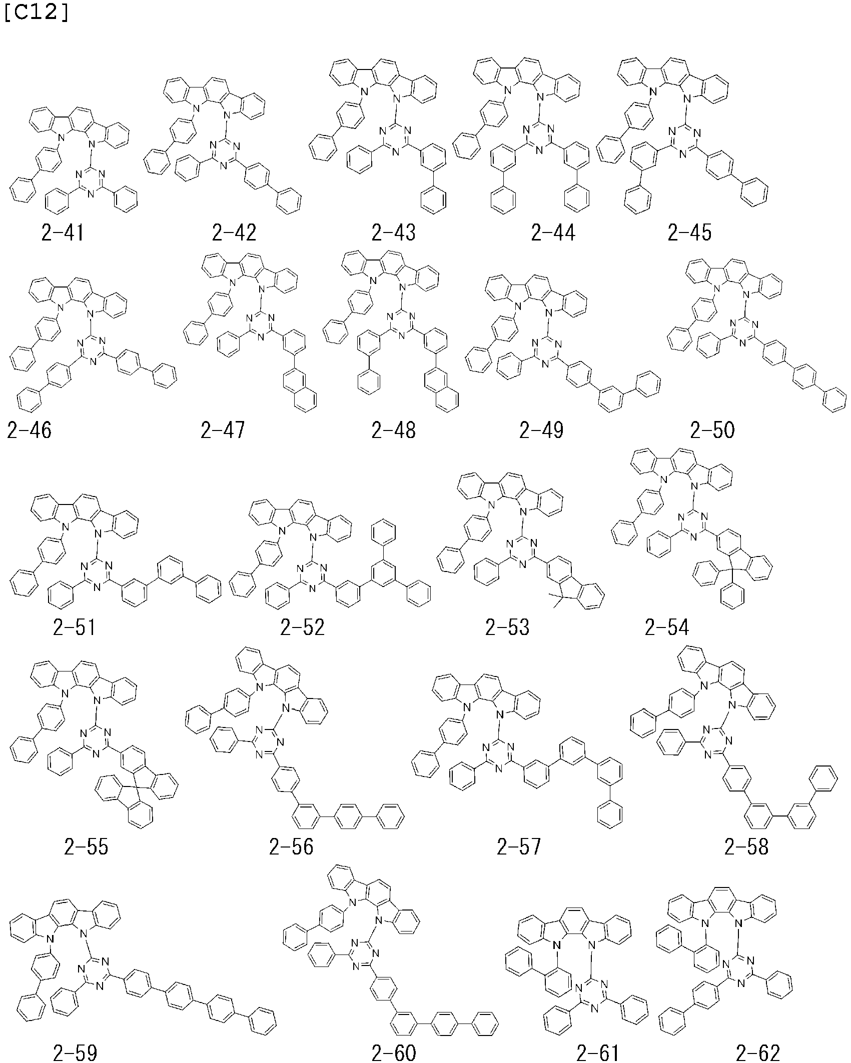

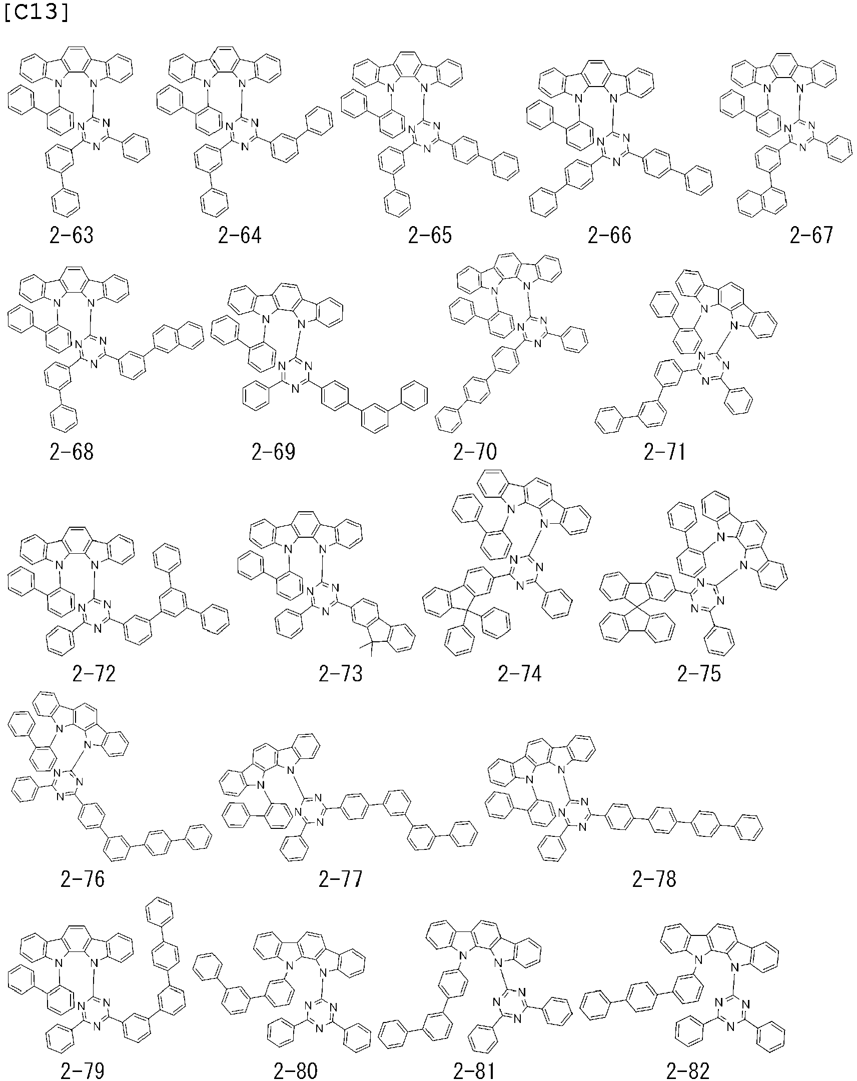

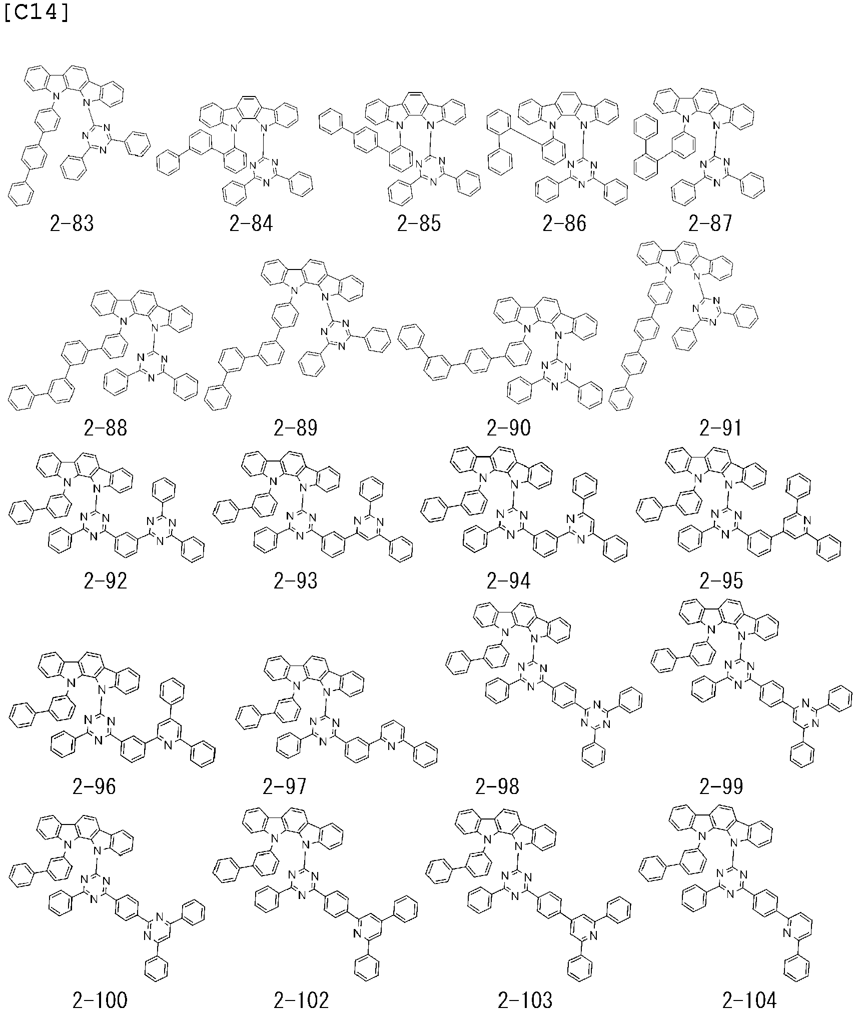

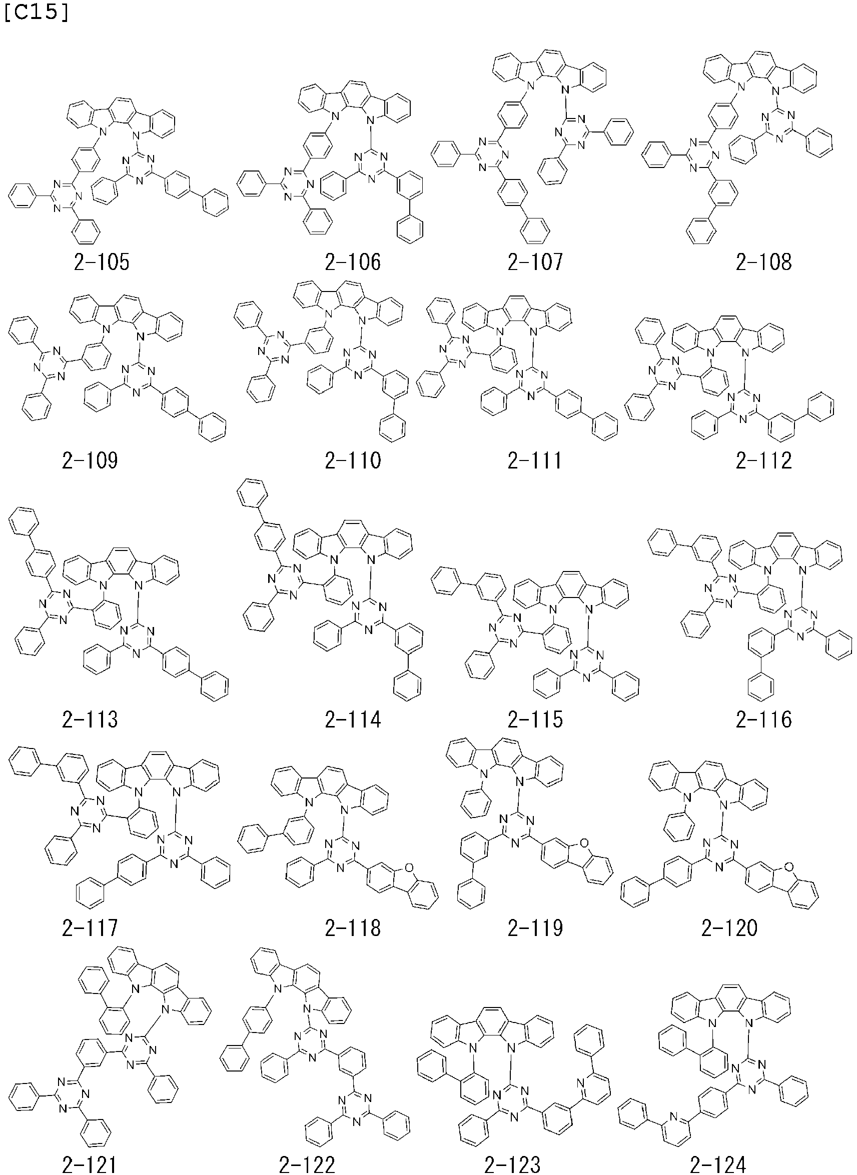

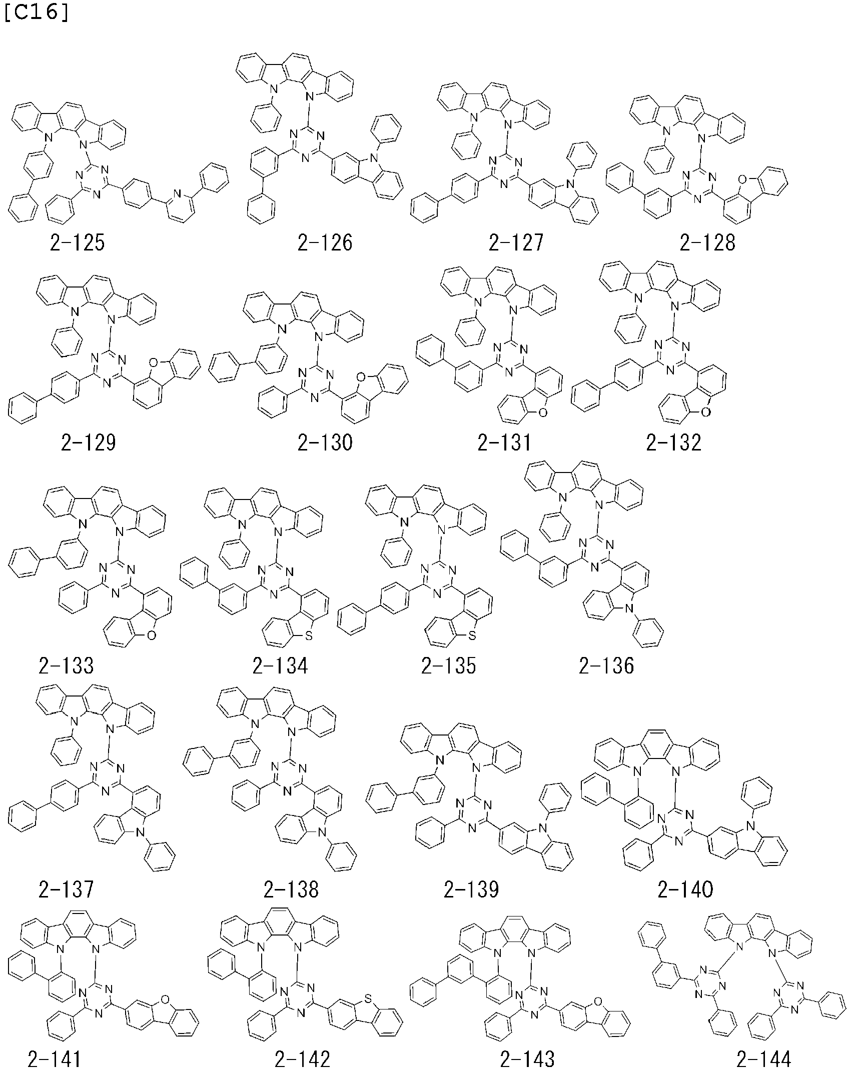

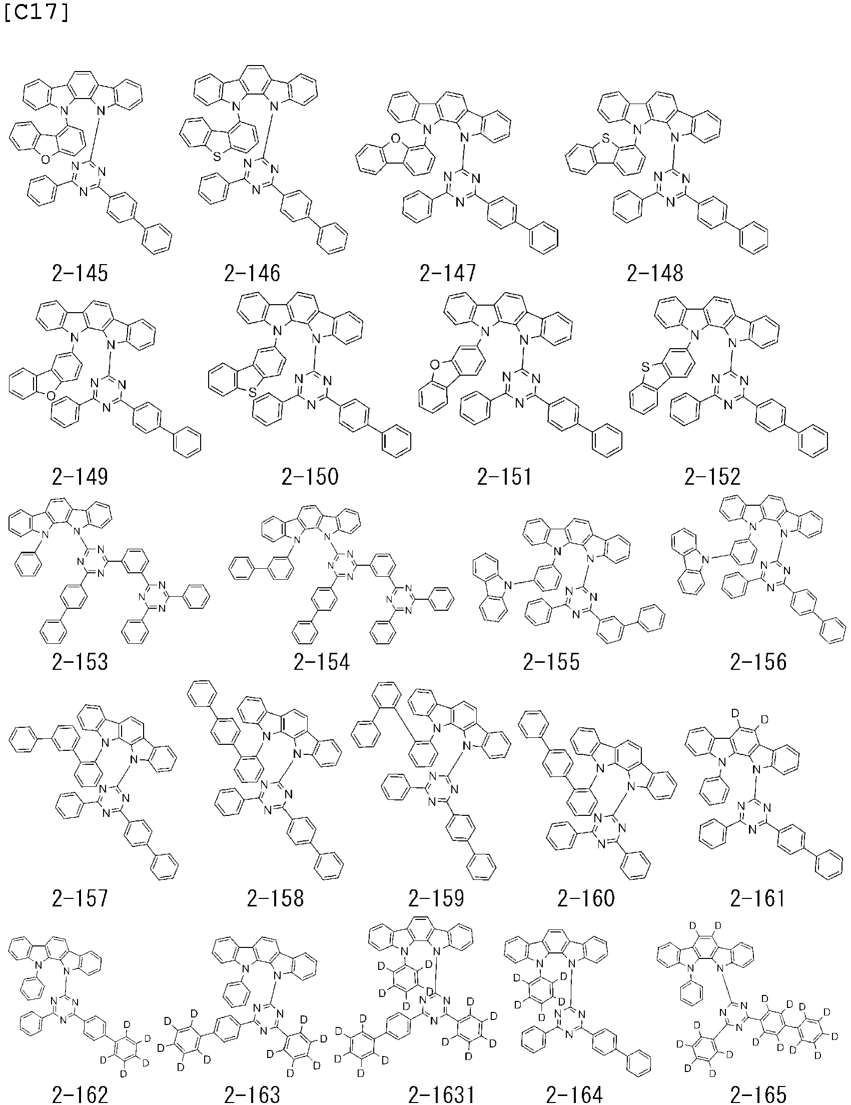

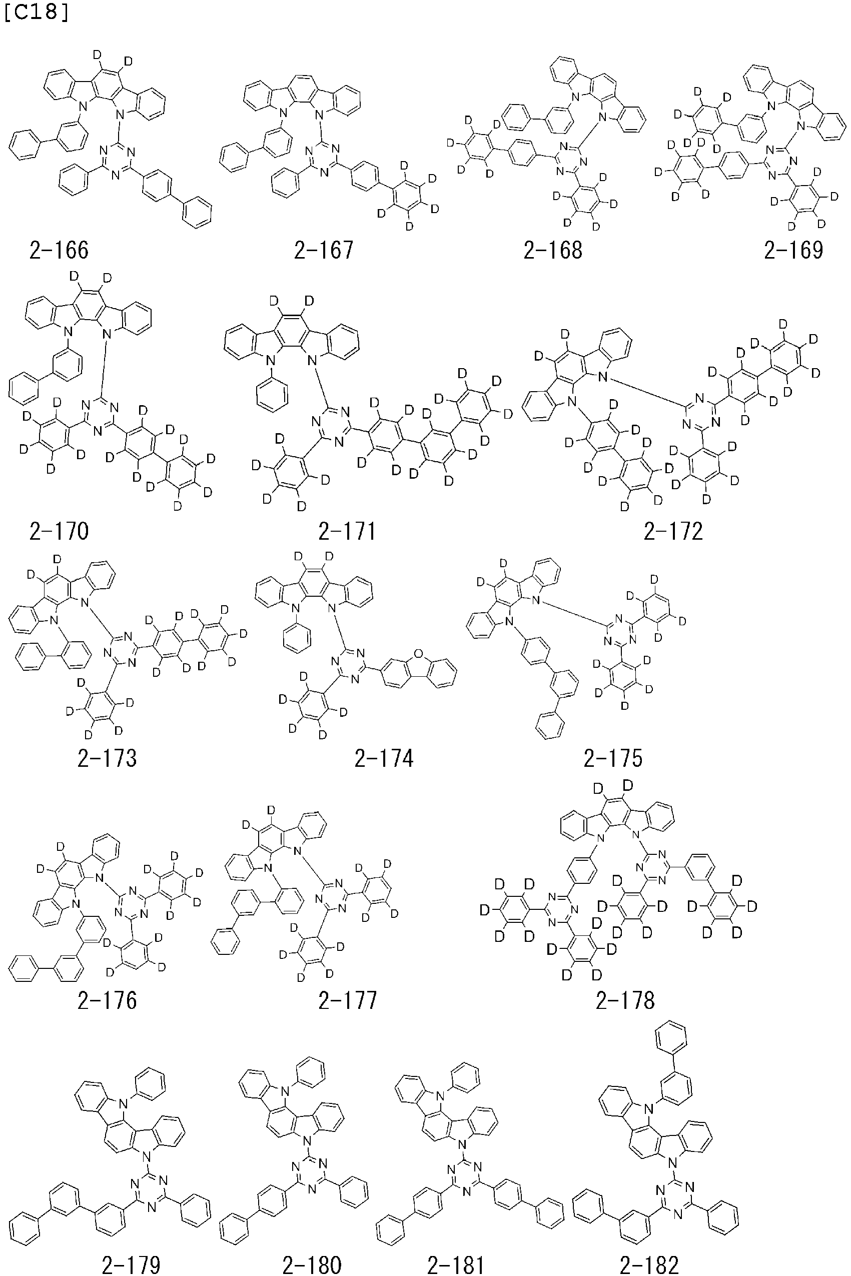

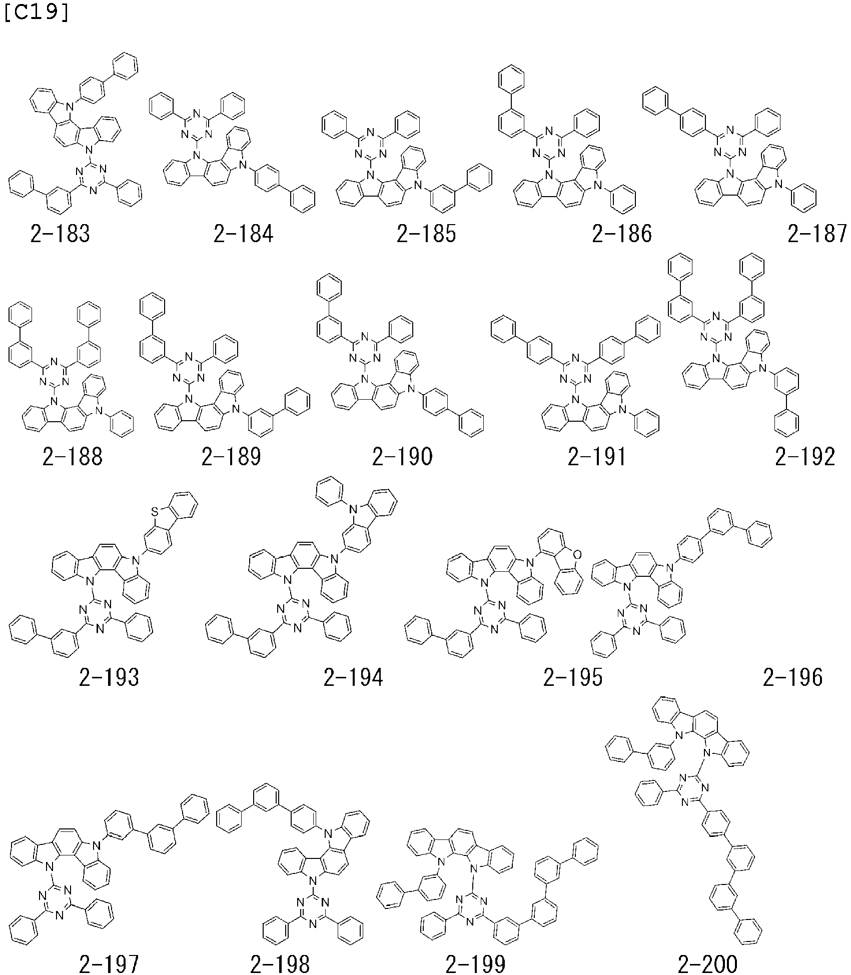

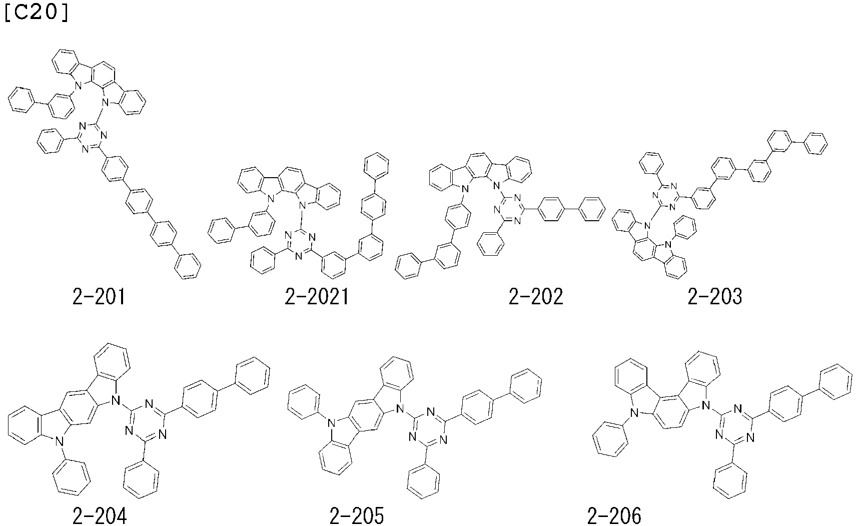

Specific examples of the compounds represented by the general formula (3) are shown below, but are not limited to these exemplified compounds.

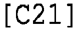

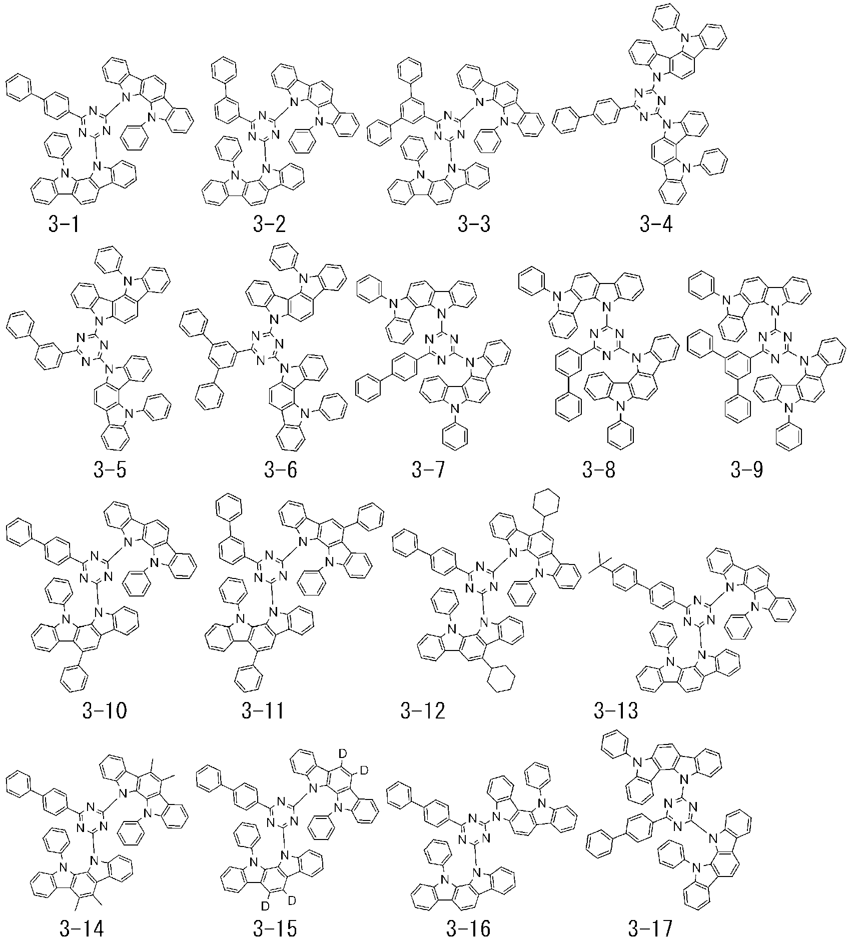

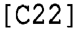

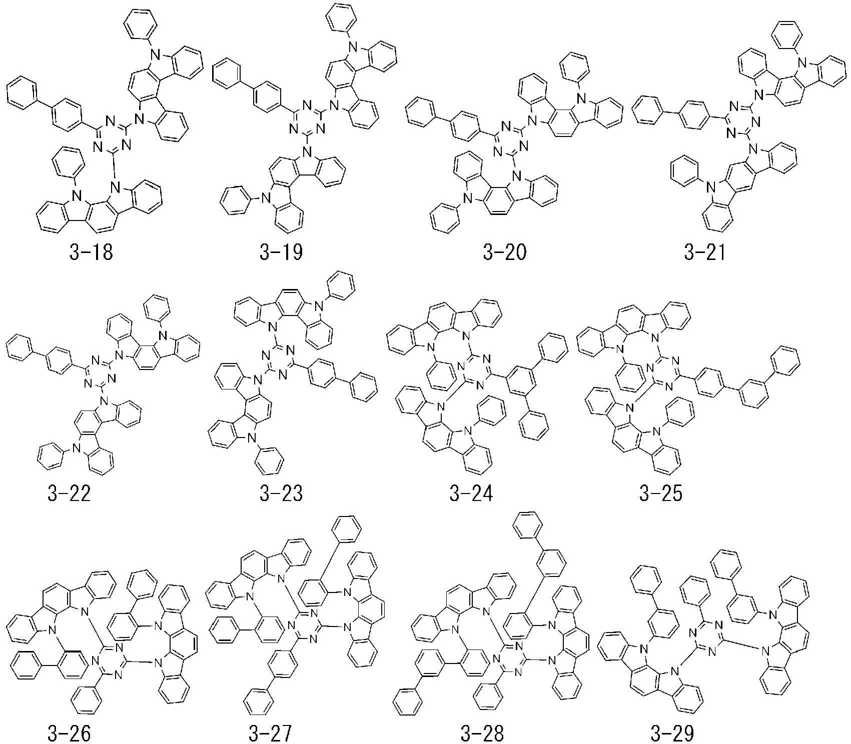

The organic EL device of the present invention has a plurality of organic layers between electrodes opposite to each other, and at least one of the organic layers is a light-emitting layer. At least one light-emitting layer contains the first host and the second host, and at least one light-emitting dopant.

Next, the structure of the organic EL device of the present invention will be described by referring to the drawing, but the structure of the organic EL device of the present invention is not limited thereto.

Figure 1 is a cross-sectional view showing a structure example of an organic EL device generally used for the present invention, in which there are indicated a substrate 1, an anode 2, a hole injection layer 3, a hole transport layer 4, a light-emitting layer 5, an electron transport layer 6, and a cathode 7. The organic EL device of the present invention may have an exciton blocking layer adjacent to the light-emitting layer and may have an electron blocking layer between the light-emitting layer and the hole injection layer. The exciton blocking layer can be inserted into either of the anode side and the cathode side of the light-emitting layer and inserted into both sides at the same time. The organic EL device of the present invention has the anode, the light-emitting layer, and the cathode as essential layers, and preferably has a hole injection transport layer and an electron injection transport layer in addition to the essential layers, and further preferably has a hole blocking layer between the light-emitting layer and the electron injection transport layer. Note that the hole injection transport layer refers to either or both of a hole injection layer and a hole transport layer, and the electron injection transport layer refers to either or both of an electron injection layer and an electron transport layer.

A structure reverse to that of Figure 1 is applicable, in which a cathode 7, an electron transport layer 6, a light-emitting layer 5, a hole transport layer 4, and an anode 2 are laminated on a substrate 1 in this order. In this case, layers may be added or omitted as necessary.

### - Substrate -

The organic EL device of the present invention is preferably supported on a substrate. The substrate is not particularly limited, and those conventionally used in organic EL devices may be used, and substrates made of, for example, glass, a transparent plastic, or quartz may be used.

### - Anode -

Regarding an anode material for an organic EL device, it is preferable to use a material of a metal, an alloy, an electrically conductive compound, and a mixture thereof, each having a large work function (4 eV or more). Specific examples of such an electrode material include a metal such as Au, and a conductive transparent material such as CuI, indium tin oxide (ITO), SnO₂, and ZnO. In addition, an amorphous material such as IDIXO (In₂O₃-ZnO), which is capable of forming a transparent conductive film, may be used. Regarding the anode, such an electrode material is used to form a thin film by, for example, a vapor-deposition or sputtering method, and a desired shape pattern may be formed by a photolithographic method; or if the pattern accuracy is not particularly required (about 100 µm or more), a pattern may be formed via a desired shape mask when the electrode material is vapor-deposited or sputtered. Alternatively, when a coatable substance such as an organic conductive compound is used, a wet film formation method such as a printing method or a coating method may be used. For taking emitted light from the anode, it is desired to have a transmittance of more than 10%, and the sheet resistance for the anode is preferably several hundreds Ω/□ or less. The film thickness is selected usually within 10 to 1000 nm, preferably within 10 to 200 nm though depending on the material.

### - Cathode -

Meanwhile, regarding a cathode material, preferable to a material of a metal (an electron injection metal), an alloy, an electrically conductive compound, or a mixture thereof, each having a small work function (4 eV or less) are used. Specific examples of such an electrode material include sodium, a sodium-potassium alloy, magnesium, lithium, a magnesium/copper mixture, a magnesium/silver mixture, a magnesium/aluminum mixture, a magnesium/indium mixture, an aluminum/aluminum oxide (Al₂O₃) mixture, indium, a lithium/aluminum mixture, and a rare earth metal. Among these, from the viewpoint of the electron injectability and the durability against oxidation and the like, a mixture of an electron injection metal and a second metal which is a stable metal having a larger work function value is suitable, and examples thereof include a magnesium/silver mixture, a magnesium/aluminum mixture, a magnesium/indium mixture, an aluminum/aluminum oxide mixture, a lithium/aluminum mixture and aluminum. The cathode can be produced by forming a thin film by a method such as vapor-depositing or sputtering of such a cathode material. In addition, the sheet resistance of cathode is preferably several hundreds Ω/□ or less. The film thickness is selected usually within 10 nm to 5 µm, preferably within 50 to 200 nm. Note that for transmission of emitted light, if either one of the anode and cathode of the organic EL device is transparent or translucent, emission luminance is improved, which is convenient.

In addition, formation of a film of the above metal with a thickness of 1 to 20 nm on the cathode, followed by formation of a conductive transparent material described in the description on the anode thereon, enables production of a transparent or translucent cathode, and application of this enables production of a device wherein an anode and a cathode both have transmittance.

### - Light-emitting layer -

The light-emitting layer is a layer that emits light after excitons are generated when holes and electrons injected from the anode and the cathode, respectively, are recombined. As a light-emitting layer, a light-emitting dopant material and a host are contained.

The first host and the second host are used as hosts.

Regarding the first host represented by the general formula (1), one kind of compound may be used, or two or more different compounds may be used. Similarly, regarding the second host represented by the general formula (2) or (3), one kind of compound may be used, or two or more different compounds may be used.

If necessary, one, or two or more other known host materials may be used in combination; however, it is preferable that an amount thereof to be used be 50 wt% or less, preferably 25 wt% or less based on the host materials in total.

A preferred method as the method for producing the organic EL device of the present invention is a method comprising providing a premixture comprising the first host and the second host and producing a light-emitting layer by use of the premixture. Additionally, a more preferred method comprises vapor-depositing the premixture by vaporization from a single evaporation source. Herein, the premixture is suitably a uniform composition.

When the first host and the second host are premixed and used, it is desirable that a difference in 50% weight reduction temperature (T₅₀) be small in order to produce an organic EL device having favorable characteristics with high reproducibility. The 50% weight reduction temperature is a temperature at which the weight is reduced by 50% when the temperature is raised to 550°C from room temperature at a rate of 10°C/min in TG-DTA measurement under a nitrogen stream reduced pressure (1 Pa). It is considered that vaporization due to evaporation or sublimation the most vigorously occurs around this temperature.

The difference in 50% weight reduction temperatures of the first host and the second host in the premixture is preferably within 20°C. The premixture can be vaporized from a single evaporation source and vapor-deposited to thereby obtain a uniform vapor-deposited film. In this case, the premixture may be mixed with a light-emitting dopant material necessary for formation of a light-emitting layer, or another host to be used as necessary. However, when there is a large difference in temperatures to provide desired vapor pressure, vapor-deposition may be performed from another vapor deposition source.

In addition, regarding the mixing ratio (weight ratio) between the first host and the second host, the proportion of the first host may be 30 to 90%, and is preferably more than 35% and less than 85%, and more preferably 50 to 70% based on the first host and the second host in total.

The premixing method is desirably a method that can allow for mixing as uniformly as possible, and examples thereof include pulverization and mixing, a heating and melting method under reduced pressure or under an atmosphere of an inert gas such as nitrogen, and sublimation, but not limited thereto.

The host and the premixture thereof may be in powder, stick, or granule form.

In the case of use of a plurality of kinds of hosts, such respective hosts can be vapor-deposited from different vapor deposition sources or can be simultaneously vapor-deposited from one vapor deposition source by premixing the hosts before vapor deposition to provide a premixture.

When a phosphorescent dopant is used as a light-emitting dopant material, preferred is a phosphorescent dopant including an organic metal complex containing at least one metal selected from ruthenium, rhodium, palladium, silver, rhenium, osmium, iridium, platinum and gold. Specifically, iridium complexes described in J. Am. Chem. Soc. 2001, 123, 4304, JP2013-530515A, US2016/0049599A, US2017/0069848A, US2018/0282356A, US2019/0036043A, or the like, or platinum complexes described in US2018/0013078A, KR2018-094482A, or the like are preferably used, but the phosphorescent dopant is not limited thereto.

Regarding the phosphorescent dopant material, only one kind thereof may be contained in the light-emitting layer, or two or more kinds thereof may be contained. A content of the phosphorescent dopant material is preferably 0.1 to 30 wt% and more preferably 1 to 20 wt% with respect to the host material.

The phosphorescent dopant material is not particularly limited, and specific examples thereof include the following.

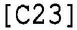

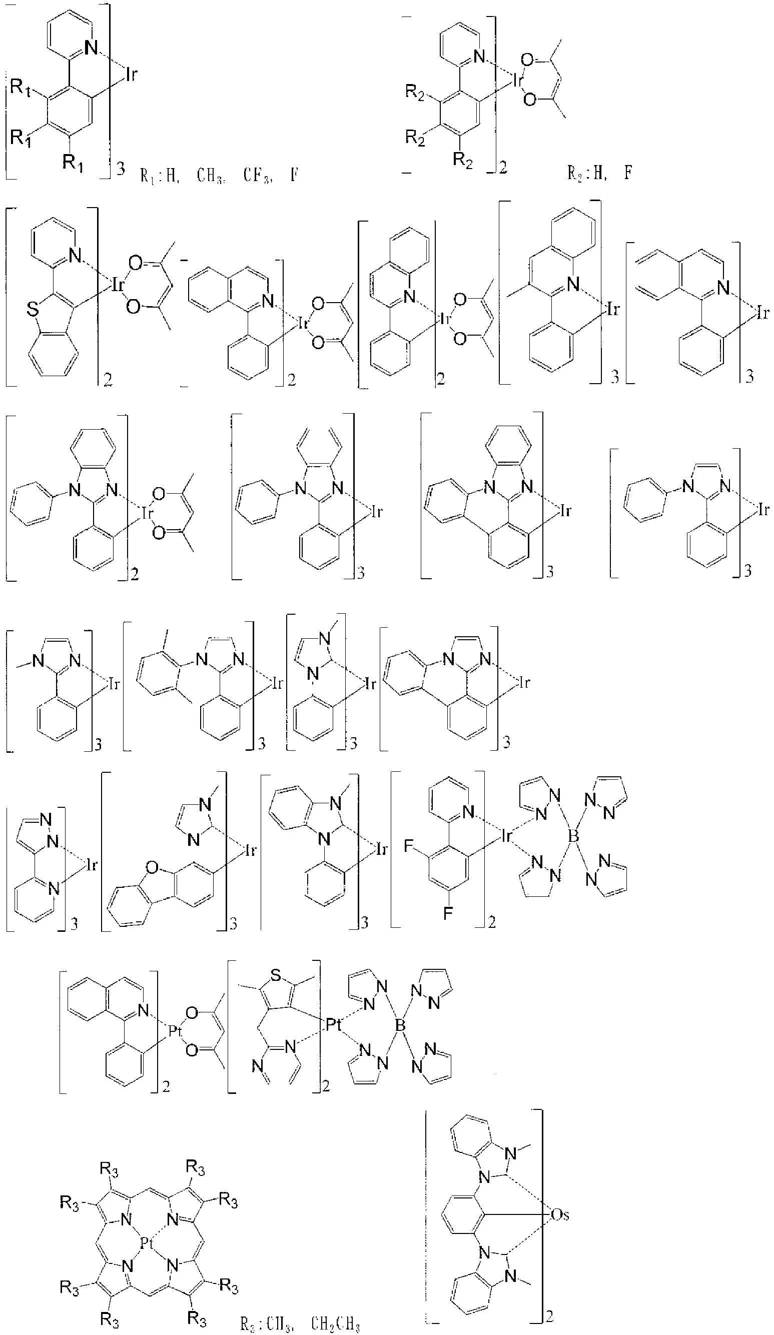

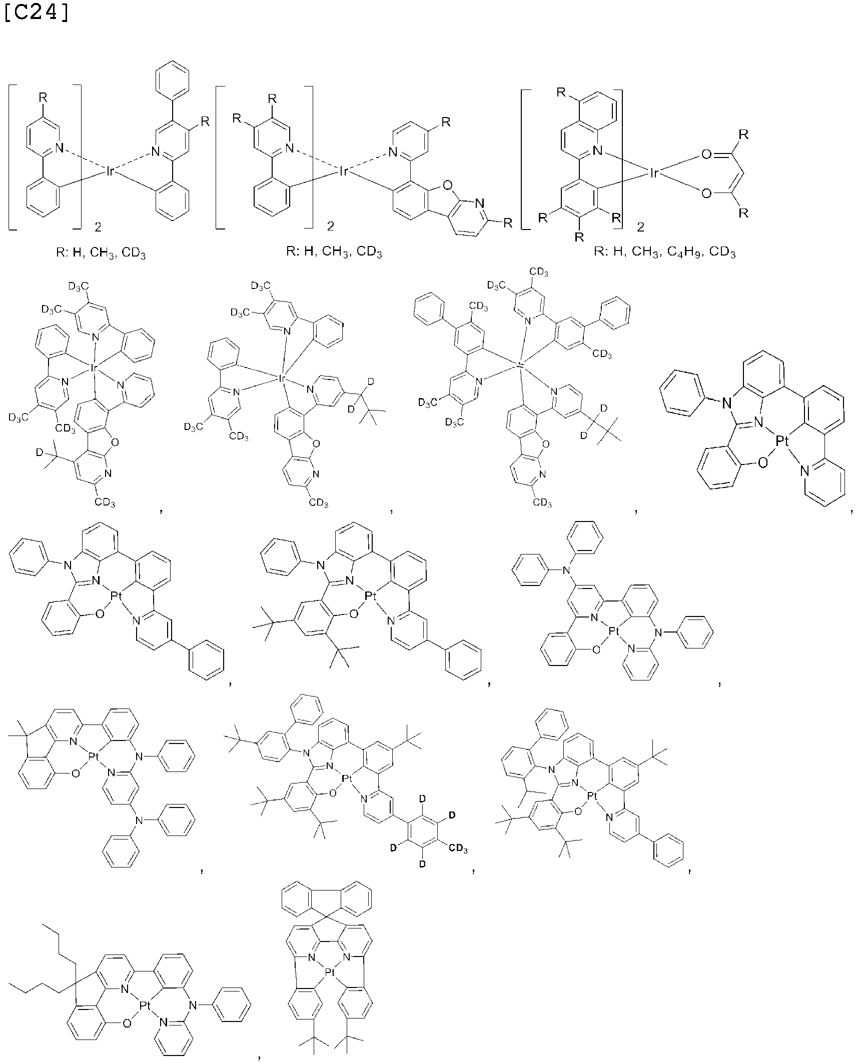

When a fluorescence-emitting dopant is used as the light-emitting dopant material, the fluorescence-emitting dopant is not particularly limited. Examples thereof include benzoxazole derivatives, benzothiazole derivatives, benzimidazole derivatives, styrylbenzene derivatives, polyphenyl derivatives, diphenylbutadiene derivatives, tetraphenyl butadiene derivatives, naphthalimido derivatives, coumarin derivatives, fused aromatic compounds, perinone derivatives, oxadiazole derivatives, oxazine derivatives, aldazine derivatives, pyrrolidine derivatives, cyclopentadiene derivatives, bisstyryl anthracene derivatives, quinacridone derivatives, pyrrolopyridine derivatives, thiadiazolopyridine derivatives, styrylamine derivatives, diketopyrrolopyrrole derivatives, aromatic dimethylidine compounds, metal complexes of 8-quinolinol derivatives or metal complexes of pyromethene derivatives, rare earth complexes, various metal complexes represented by transition metal complexes, polymer compounds such as polythiophene, polyphenylene, and polyphenylene vinylene, and organosilane derivatives. Preferred examples thereof include fused aromatic derivatives, styryl derivatives, diketopyrrolopyrrole derivatives, oxazine derivatives, pyromethene metal complexes, transition metal complexes, and lanthanoid complexes. More preferable examples thereof include naphthalene, pyrene, chrysene, triphenylene, benzo[c]phenanthrene, benzo[a]anthracene, pentacene, perylene, fluoranthene, acenaphthofluoranthene, dibenzo[a,j]anthracene, dibenzo[a,h]anthracene, benzo[a]naphthalene, hexacene, naphtho[2,1-f]isoquinoline, α-naphthaphenanthridine, phenanthrooxazole, quinolino[6,5-f]quinoline, and benzothiophanthrene. These may have an alkyl group, an aryl group, an aromatic heterocyclic group, or a diarylamino group as a substituent.

When a thermally activated delayed fluorescence-emitting dopant is used as the light-emitting dopant material, the thermally activated delayed fluorescence-emitting dopant is not particularly limited. Examples thereof include: metal complexes such as a tin complex and a copper complex; indolocarbazole derivatives described in WO2011/070963A; cyanobenzene derivatives and carbazole derivatives described in Nature 2012, 492, 234; and phenazine derivatives, oxadiazole derivatives, triazole derivatives, sulfone derivatives, phenoxazine derivatives, and acridine derivatives described in Nature Photonics 2014, 8,326.

The thermally activated delayed fluorescence-emitting dopant material is not particularly limited, and specific examples thereof include the following.

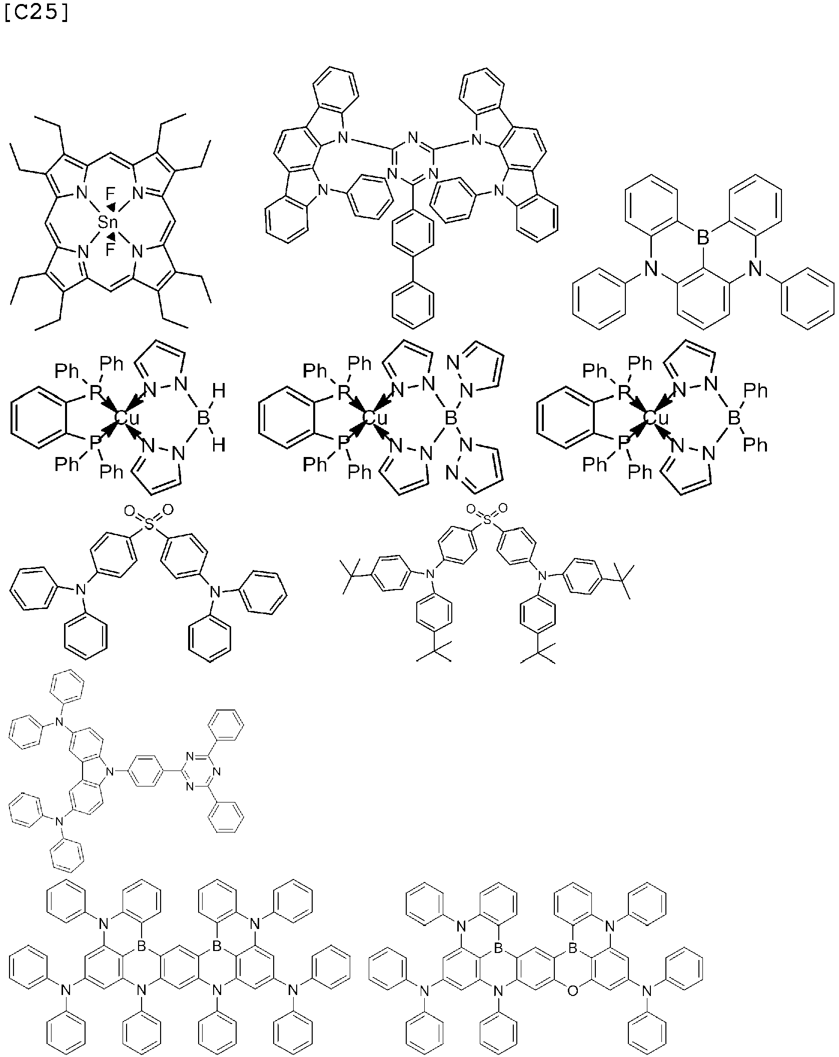

Regarding the thermally activated delayed fluorescence-emitting dopant material, only one kind thereof may be contained in the light-emitting layer, or two or more kinds thereof may be contained. In addition, the thermally activated delayed fluorescence-emitting dopant may be used by mixing with a phosphorescent dopant and a fluorescence-emitting dopant. A content of the thermally activated delayed fluorescence-emitting dopant material is preferably 0.1% to 50% and more preferably 1% to 30% with respect to the host material.

### - Injection Layer -

The injection layer is a layer that is provided between an electrode and an organic layer in order to lower a driving voltage and improve emission luminance, and includes a hole injection layer and an electron injection layer, and may be present between the anode and the light-emitting layer or the hole transport layer, and between the cathode and the light-emitting layer or the electron transport layer. The injection layer can be provided as necessary.

### - Hole Blocking Layer -

The hole blocking layer has a function of the electron transport layer in a broad sense, and is made of a hole blocking material having a function of transporting electrons and a significantly low ability to transport holes, and can block holes while transporting electrons, thereby improving a probability of recombining electrons and holes in the light-emitting layer.

### - Electron Blocking Layer -

The electron blocking layer has a function of a hole transport layer in a broad sense and blocks electrons while transporting holes, thereby enabling a probability of recombining electrons and holes in the light-emitting layer to be improved.

Regarding the material of the electron blocking layer, a known electron blocking layer material can be used and a material of the hole transport layer to be described below can be used as necessary. A film thickness of the electron blocking layer is preferably 3 to 100 nm, and more preferably 5 to 30 nm.

### - Exciton Blocking Layer -

The exciton blocking layer is a layer for preventing excitons generated by recombination of holes and electrons in the light-emitting layer from being diffused in a charge transport layer, and insertion of this layer allows excitons to be efficiently confined in the light-emitting layer, enabling the luminous efficiency of the device to be improved. The exciton blocking layer can be inserted, in a device having two or more light-emitting layers adjacent to each other, between two adjacent light-emitting layers.

Regarding the material of the exciton blocking layer, a known exciton blocking layer material can be used. Examples thereof include 1,3-dicarbazolyl benzene (mCP) and bis(8-hydroxy-2-methylquinoline)-(4-phenylphenoxy)aluminum (III) (BAlq).

### - Hole Transport Layer -

The hole transport layer is made of a hole transport material having a function of transporting holes, and the hole transport layer can be provided as a single layer or a plurality of layers.

The hole transport material has either hole injection, transport properties or electron barrier properties, and may be an organic material or an inorganic material. For the hole transport layer, any one selected from conventionally known compounds can be used. Examples of such a hole transport material include porphyrin derivatives, arylamine derivatives, triazole derivatives, oxadiazole derivatives, imidazole derivatives, polyarylalkane derivatives, pyrazoline derivatives and pyrazolone derivatives, phenylenediamine derivatives, arylamine derivatives, amino-substituted chalcone derivatives, oxazole derivatives, styryl anthracene derivatives, fluorenone derivatives, hydrazone derivatives, stilbene derivatives, silazane derivatives, an aniline copolymer, and a conductive polymer oligomer, and particularly a thiophene oligomer. Use of porphyrin derivatives, arylamine derivatives, or styrylamine derivatives preferred. Use of arylamine compounds is more preferred.

### - Electron Transport Layer -

The electron transport layer is made of a material having a function of transporting electrons, and the electron transport layer can be provided as a single layer or a plurality of layers.

The electron transport material (which may also serve as a hole blocking material) may have a function of transferring electrons injected from the cathode to the light-emitting layer. For the electron transport layer, any one selected from conventionally known compounds can be used, and examples thereof include polycyclic aromatic derivatives such as naphthalene, anthracene, and phenanthroline, tris(8-hydroxyquinoline)aluminum(III) derivatives, phosphine oxide derivatives, nitro-substituted fluorene derivatives, diphenylquinone derivatives, thiopyrandioxide derivatives, carbodiimide, fluorenylidene methane derivatives, anthraquinodimethane and anthrone derivatives, bipyridine derivatives, quinoline derivatives, oxadiazole derivatives, benzimidazole derivatives, benzothiazole derivatives, and indolocarbazole derivatives. In addition, a polymer material in which the above material is introduced into a polymer chain or the above material is used for a main chain of a polymer can be used.

### Examples

Hereafter, the present invention will be described in detail by referring to Examples, but the present invention is not limited to these Examples and can be implemented in various forms without departing from the gist thereof.

### Synthesis Example 1

The above-described compound (1-1) was synthesized in accordance with the next reaction formula.

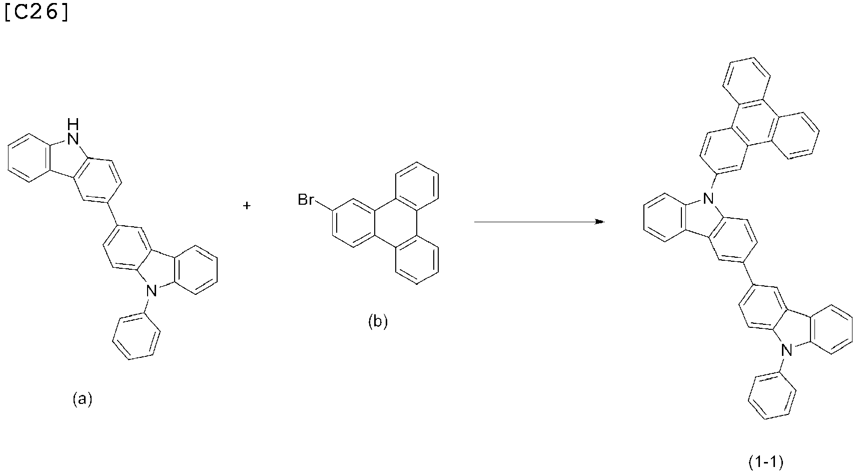

To 10 g of a compound (a) were added 9.0 g of a compound (b), 932 mg of copper iodide, 6.09 g of potassium carbonate, 709 mg of 8-quinolinol, and 100 ml of 1,3-dimethyl-2-imidazolidinone, and the mixture was stirred at 180°C for 20 hours under nitrogen reflux. The reactant was separated and purified to yield 7.7 g of a yellow solid compound (1-1).

The above-described compounds 1-2 and 1-4 were synthesized according to the Synthesis Example. Compounds 2-22 and 2-37 were also synthesized according to the Synthesis Example in the same manner. Compounds H-1 and H-2 were further synthesized for comparison. Compounds A was also synthesized for comparison.

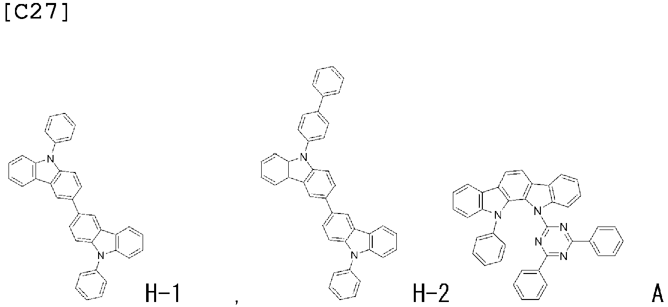

### Example 1

On a glass substrate on which an anode made of ITO with a film thickness of 110 nm was formed, respective thin films were laminated by a vacuum evaporation method at a degree of vacuum of 4.0 × 10⁻⁵ Pa. First, HAT-CN was formed with a thickness of 25 nm as a hole injection layer on ITO, and next, Spiro-TPD was formed with a thickness of 30 nm as a hole transport layer. Next, HT-1 was formed with a thickness of 10 nm as an electron blocking layer. Then, compound 1-1 as a first host, compound 2-22 as a second host and Ir(ppy)₃ as a light-emitting dopant were co-vapor-deposited from different vapor deposition sources, respectively, to form a light-emitting layer with a thickness of 40 nm. In this case, co-vapor deposition was performed under vapor deposition conditions such that the concentration of Ir(ppy)₃ was 10 wt%, and the weight ratio between the first host and the second host was 70:30. Next, ET-1 was formed with a thickness of 20 nm as an electron transport layer. Further, LiF was formed with a thickness of 1 nm as an electron injection layer on the electron transport layer. Finally, Al was formed with a thickness of 70 nm as a cathode on the electron injection layer to produce an organic EL device. The compounds appearing here are summarized below except for those described above.

### Examples 2 to 20, 24 to 27

Organic EL devices were produced in the same manner as in Example 1 except that compounds shown in Table 1 were used as the first host and the second host and the weight ratio was as shown in Table 1.

### Examples 21 to 23

A premixture was obtained by weighing compounds shown in Table 1, used as a first host and a second host, at a weight ratio shown in Table 1 and mixing them while grinding in a mortar. Organic EL devices were produced in the same manner as in Example 1 except that the premixture was vapor-deposited from one vapor deposition source.

### Comparative Examples 1 to 7

Organic EL devices were produced in the same manner as in Example 1 except that compounds shown in Table 1 were used as the first host and the second host and the weight ratio was as shown in Table 1.

### Comparative Example 8

An organic EL device was produced in the same manner as in Example 1 except that only a first host shown in Table 1 was used as a host compound.

### Comparative Examples 9 to 10

An organic EL device was produced in the same manner as in Example 1 except that only a second host shown in Table 1 was used as a host compound.

Evaluation results of the produced organic EL devices are shown in Table 1. In the table, the luminance, driving voltage, power efficiency, and LT70 are values at a driving current of 20 mA/cm². LT70 is a time period needed for the initial luminance (luminance described in table) to be reduced to 70%, and it represents lifetime characteristics. The numbers with which the first host and the second host are marked are numbers with which the exemplified compounds are marked.

**[Table 1]**

| | First host | Second host | Weight ratio | Driving voltage (V) | Luminance (cd/m²) | Power efficiency (Im/W) | LT70 (h) |
|---|---|---|---|---|---|---|---|
| Example 1 | 1-1 | 2-22 | 70:30 | 4.9 | 12200 | 39.0 | 2700 |
| Example 2 | 1-2 | 2-22 | 70:30 | 5.0 | 12500 | 39.2 | 2700 |
| Example 3 | 1-4 | 2-22 | 70:30 | 5.1 | 12500 | 38.8 | 2800 |
| Example 4 | 1-29 | 2-22 | 70:30 | 5.0 | 11500 | 36.4 | 2500 |
| Example 5 | 1-1 | 2-37 | 70:30 | 4.6 | 12900 | 43.6 | 2700 |
| Example 6 | 1-2 | 2-37 | 70:30 | 4.7 | 12600 | 41.7 | 2700 |
| Example 7 | 1-4 | 2-37 | 70:30 | 4.8 | 12600 | 41.3 | 2700 |
| Example 8 | 1-29 | 2-37 | 70:30 | 4.7 | 11600 | 38.4 | 2500 |
| Example 9 | 1-1 | 2-38 | 70:30 | 4.7 | 12500 | 41.8 | 2300 |
| Example 10 | 1-1 | 2-40 | 70:30 | 5.2 | 13200 | 40.2 | 2700 |
| Example 11 | 1-1 | 2-80 | 70:30 | 4.8 | 11400 | 37.6 | 2400 |
| Example 12 | 1-1 | 2-81 | 70:30 | 4.9 | 12400 | 39.9 | 2400 |
| Example 13 | 1-1 | 2-106 | 70:30 | 4.6 | 12000 | 40.7 | 2800 |
| Example 14 | 1-1 | 2-185 | 70:30 | 5.0 | 12400 | 39.2 | 2300 |
| Example 15 | 1-1 | 2-186 | 70:30 | 5.3 | 13500 | 39.9 | 2300 |
| Example 16 | 1-1 | 2-202 | 70:30 | 5.2 | 12700 | 38.7 | 2800 |
| Example 17 | 1-1 | 2-204 | 70:30 | 5.1 | 12300 | 37.9 | 2300 |
| Example 18 | 1-1 | 2-205 | 70:30 | 5.5 | 12000 | 34.3 | 2300 |
| Example 19 | 1-1 | 2-206 | 70:30 | 5.2 | 12000 | 35.9 | 2300 |
| Example 20 | 1-1 | 3-1 | 70:30 | 5.2 | 12700 | 38.7 | 2800 |
| Example 21 | 1-1 | 2-40 | 70:30 | 4.6 | 12200 | 41.2 | 2900 |
| Example 22 | 1-1 | 2-106 | 70:30 | 5.3 | 12700 | 37.8 | 3000 |
| Example 23 | 1-1 | 2-202 | 70:30 | 5.1 | 12600 | 38.8 | 3000 |
| Example 24 | 1-1 | 2-22 | 60:40 | 4.3 | 11200 | 41.0 | 2200 |
| Example 25 | 1-1 | 2-106 | 60:40 | 4.4 | 12300 | 43.5 | 1600 |
| Example 26 | 1-1 | 2-22 | 50:50 | 3.8 | 11500 | 47.4 | 1600 |
| Example 27 | 1-1 | 2-106 | 50:50 | 4.2 | 12100 | 45.6 | 1100 |
| Comp. Example 1 | H-1 | A | 70:30 | 5.8 | 12000 | 32.7 | 2000 |
| Comp. Example 2 | 1-1 | A | 70:30 | 5.6 | 12000 | 33.4 | 1600 |
| Comp. Example 3 | H-2 | 2-22 | 70:30 | 5.7 | 11800 | 32.7 | 2400 |
| Comp. Example 4 | H-1 | 2-80 | 70:30 | 5.6 | 12400 | 34.5 | 1300 |
| Comp. Example 5 | 1-1 | 2-80 | 70:30 | 5.5 | 12400 | 35.2 | 1900 |
| Comp. Example 6 | H-1 | A | 50:50 | 5.5 | 13200 | 37.9 | 800 |
| Comp. Example 7 | 1-1 | A | 50:50 | 5.4 | 13200 | 38.7 | 600 |
| Comp. Example 8 | 1-1 | - | - | 4.6 | 8100 | 27.9 | 200 |
| Comp. Example 9 | - | 2-80 | - | 3.5 | 10500 | 47.1 | 700 |
| Comp. Example 10 | - | A | - | 3.4 | 9000 | 41.8 | 300 |

From the results in Table 1, it is understood that Examples 1 to 27 exhibited high power efficiency and favorable lifetime characteristics as compared with Comparative Examples.

Compounds used in Examples are shown below.

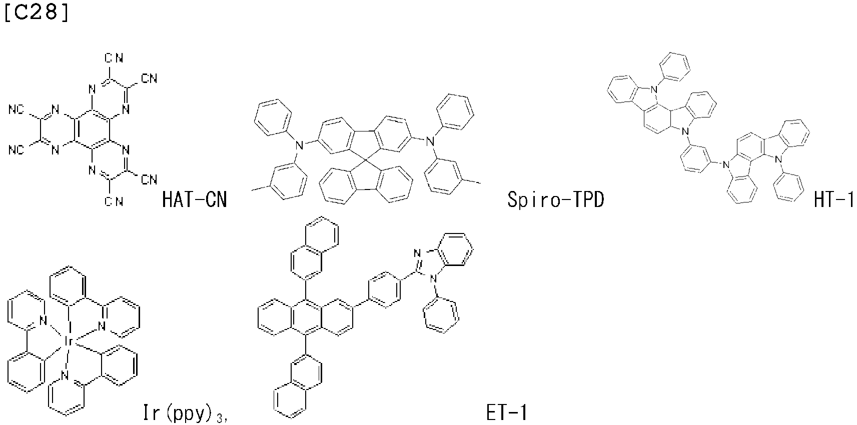

Table 2 shows the 50% weight reduction temperatures (T₅₀) of compounds 1-1, 2-40, 2-106, and 2-202 for the first and second hosts used in Examples 21 to 23.

**[Table 2]**

| **Compound** | **T₅₀[°C]** |
|---|---|
| **1-1** | **320** |
| **2-40** | **331** |
| **2-106** | **316** |
| **2-202** | **301** |

### Reference Signs List

1 substrate, 2 anode, 3 hole injection layer, 4 hole transport layer, 5 light-emitting layer, 6 electron transport layer, 7 cathode.

## Claims

1. An organic electroluminescent device comprising one or more light-emitting layers between an anode and a cathode opposite to each other, wherein at least one of the light-emitting layers contains a first host selected from a compound represented by the following general formula (1), a second host selected from a compound represented by the following general formula (2) or general formula (3), and a light-emitting dopant material: 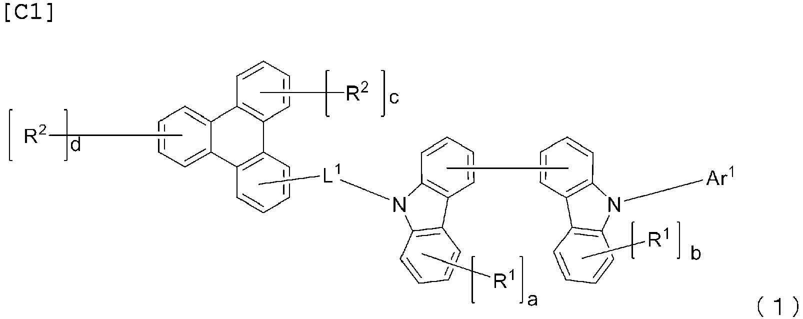
wherein Ar¹ in the general formula (1) represents a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five of these aromatic groups are linked to each other;
L¹ represents a direct bond, a substituted or
unsubstituted aromatic hydrocarbon group having 6 to 17 carbon atoms, or a substituted or unsubstituted aromatic heterocyclic group having 3 to 17 carbon atoms,
provided that, when Ar¹ and L¹ represent the aromatic heterocyclic group or the linked aromatic group, a group directly bound to a carbazole ring in the formula is not a carbazolyl group;
R¹ and R² each independently represent deuterium, an aliphatic hydrocarbon group having 1 to 10 carbon atoms, a substituted or unsubstituted aromatic hydrocarbon group having 6 to 18 carbon atoms, or a substituted or
unsubstituted aromatic heterocyclic group having 3 to 17 carbon atoms; and
a to d represent the number of substitutions, a and b each independently represent an integer of 0 to 4, and c and d each independently represent an integer of 0 to 2; 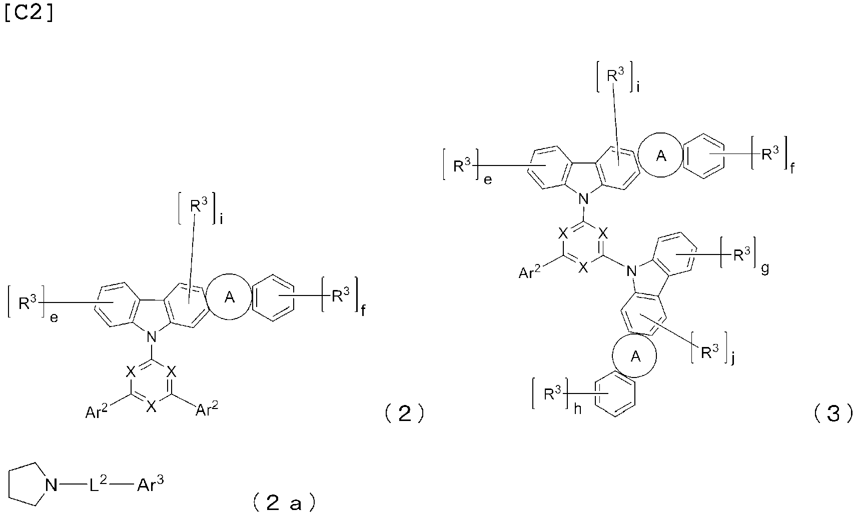
wherein a ring A in the general formula (2) and the general formula (3) is a heterocycle fused to two adjacent rings at any positions and represented by the general formula (2a),
Ar² and Ar³ each independently represent a substituted or unsubstituted aromatic hydrocarbon group having 6 to 25 carbon atoms excluding a triphenylene group, a substituted or unsubstituted aromatic heterocyclic group having 3 to 17 carbon atoms, or a substituted or unsubstituted linked aromatic group in which two to five of these aromatic rings are linked to each other, and at least one of Ar² and Ar³ represents a substituted or unsubstituted linked aromatic group in which two to five phenyl groups are linked to each other;
L² represents a direct bond or a substituted or unsubstituted aromatic hydrocarbon group having 6 to 17 carbon atoms;
each R³ independently represents deuterium, or an aliphatic hydrocarbon group having 1 to 10 carbon atoms;
e to j represent the number of substitutions, e to h each independently represent an integer of 0 to 4, and i to j each independently represent an integer of 0 to 2; and
each X independently represents N or C-H and at least one thereof represents N.

2. The organic electroluminescent device according to claim 1, wherein the compound represented by the general formula (1) is represented by the following general formula (4) or (5): 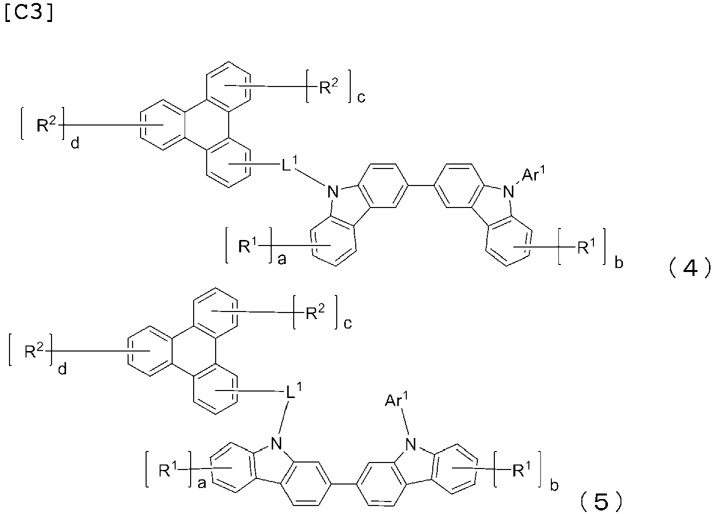 wherein Ar¹, L¹, R¹, R², and a to d have the same meaning as in the general formula (1).

3. The organic electroluminescent device according to claim 1 or 2, wherein L¹ in the general formula (1) and the formulas (4) to (5) represents a direct bond.

4. The organic electroluminescent device according to claim 3, wherein Ar¹ represents a substituted or unsubstituted aromatic hydrocarbon group having 6 to 18 carbon atoms, or a substituted or unsubstituted linked aromatic group in which two to five of these aromatic groups are linked to each other.

5. The organic electroluminescent device according to claim 4, wherein Ar¹ represents a substituted or unsubstituted phenyl group, or a substituted or unsubstituted linked aromatic group in which two to five phenyl groups are linked to each other.

6. The organic electroluminescent device according to any one of claims 1 to 5, wherein all of a to d, in the general formula (1) and the general formulas (4) to (5), represent 0.

7. The organic electroluminescent device according to any one of claims 1 to 6, wherein the general formula (2) is represented by any of the following general formulas (6) to (9): 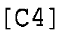 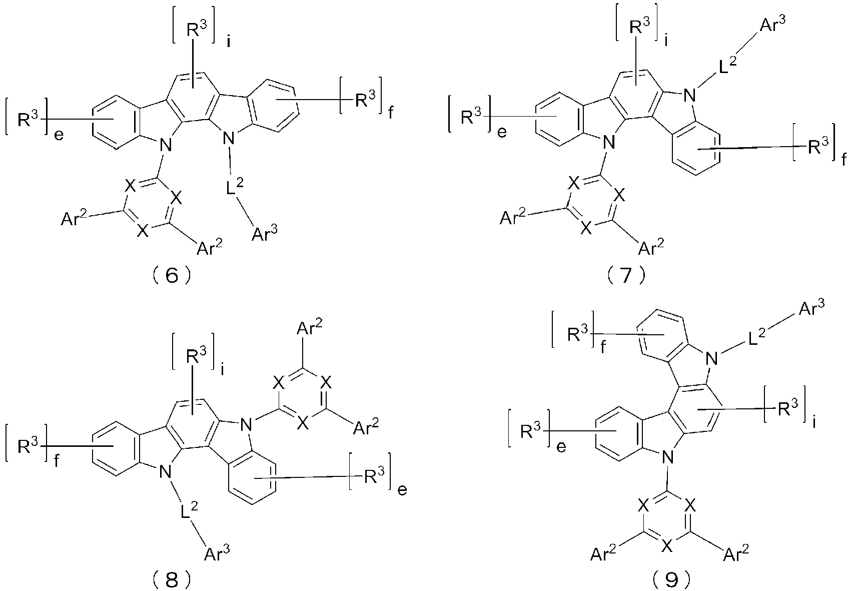 wherein Ar², Ar³, L², R³, e, f, i, and X have the same meaning as in the general formula (2).

8. The organic electroluminescent device according to any one of claims 1 to 7, wherein the general formula (3) is represented by any of the following general formulas (10) to (13): 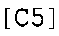 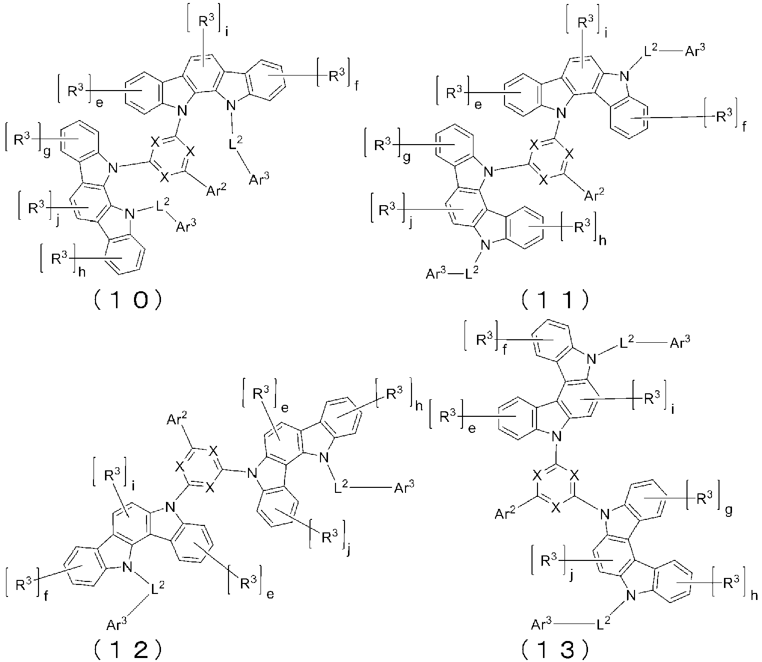 wherein Ar², Ar³, L², R³, e to j, and X have the same meaning as in the general formula (3).

9. The organic electroluminescent device according to any one of claims 1 to 8, wherein all of X in the general formulas (2) and (3) represent N.

10. The organic electroluminescent device according to any one of claims 1 to 9, wherein at least one of Ar² and Ar³ in the general formulas (2) and (3) is a group represented by the following general formula (2c): 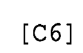 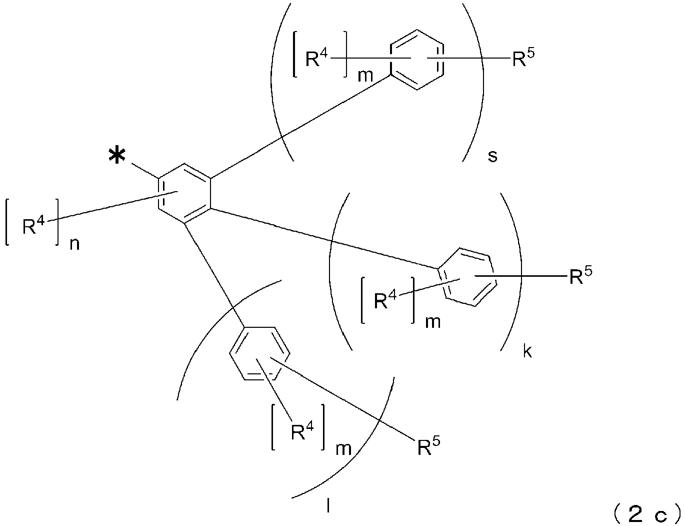 wherein each R⁴ independently represents deuterium or an aliphatic hydrocarbon group having 1 to 10 carbon atoms, each R⁵ independently represents hydrogen, deuterium, or an aliphatic hydrocarbon group having 1 to 10 carbon atoms, each m independently represents an integer of 0 to 4, n represents an integer of 0 to 2, s, k, and l represent an integer of 0 to 4, and 1 ≤ s + k + 1 ≤ 4 is satisfied; and * represents a bonding position as a substituent.

11. The organic electroluminescent device according to claim 10, wherein m in the general formula (2c) represents 0.

12. The organic electroluminescent device according to any one of claims 1 to 11, wherein the second host is a compound selected from the group consisting of the general formula (2).

13. The organic electroluminescent device according to any one of claims 1 to 12, wherein the light-emitting dopant material is an organic metal complex containing at least one metal selected from the group consisting of ruthenium, rhodium, palladium, silver, rhenium, osmium, iridium, platinum and gold.

14. The organic electroluminescent device according to any one of claims 1 to 12, wherein the light-emitting dopant material is a thermally activated delayed fluorescence-emitting dopant material.

15. A method for producing the organic
electroluminescent device according to any one of claims 1 to 14, comprising a step of mixing a first host and a second host to form a premixture and then vapor-depositing a host material containing the premixture to form a light-emitting layer.

16. The method for producing the organic electroluminescent device according to claim 15, wherein a difference in 50% weight reduction temperatures of the first host and the second host is within 20°C.

17. A premixture for formation of a light-emitting layer of an organic electroluminescent device, by premixing a first host and a second host and vapor-depositing them from the same vapor deposition source, wherein the first host is selected from a compound represented by the following general formula (1), the second host is selected from a compound represented by the following general formula (2) or general formula (3), and a difference in 50% weight reduction temperatures of the first host and the second host is within 20°C: 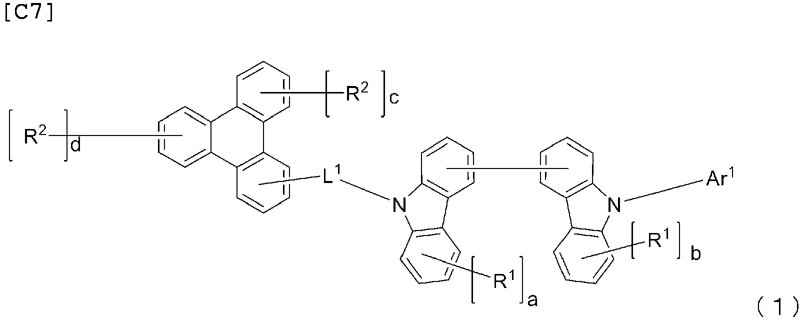
wherein Ar¹ in the general formula (1) represents a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five of these aromatic groups are linked to each other;
L¹ represents a direct bond, a substituted or unsubstituted aromatic hydrocarbon group having 6 to 17 carbon atoms, or a substituted or unsubstituted aromatic heterocyclic group having 3 to 17 carbon atoms, provided that, when Ar¹ and L¹ represent the aromatic heterocyclic group or the linked aromatic group, a group directly bound to a carbazole ring in the formula is not a carbazolyl group;
R¹ and R² each independently represent deuterium, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms;
a to d represent the number of substitutions, a and b each independently represent an integer of 0 to 4, and c and d each independently represent an integer of 0 to 2; 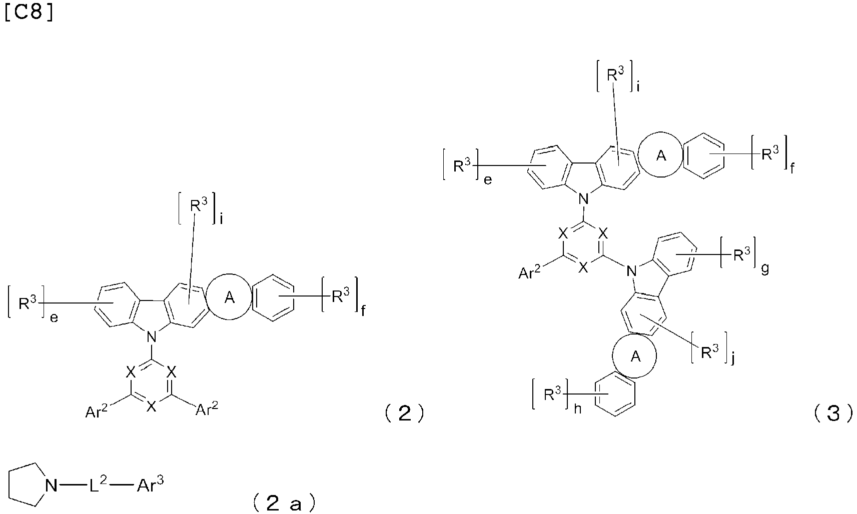
wherein a ring A in the general formula (2) and the general formula (3) is a heterocycle fused to two adjacent rings at any positions and represented by general formula (2a),
Ar² and Ar³ each independently represent a substituted or unsubstituted aromatic hydrocarbon group having 6 to 25 carbon atoms excluding a triphenylene group, a substituted or unsubstituted aromatic heterocyclic group having 3 to 17 carbon atoms, or a substituted or unsubstituted linked aromatic group in which two to five of these aromatic groups are linked to each other, and at least one of Ar² and Ar³ represents a substituted or unsubstituted linked aromatic group in which two to five phenyl groups are linked to each other;
L² represents a direct bond or a substituted or unsubstituted aromatic hydrocarbon group having 6 to 17 carbon atoms,
each R³ independently represents deuterium, or an aliphatic hydrocarbon group having 1 to 10 carbon atoms;
e to j represent the number of substitutions, e to h each independently represent an integer of 0 to 4, and i to j each independently represent an integer of 0 to 2; and
each X independently represents N or C-H and at least one thereof represents N.
